(19) Europäisches Patentamt / European Patent Office / Office européen des brevets

(11) **EP 4 456 048 A1**

(12) **EUROPEAN PATENT APPLICATION**
published in accordance with Art. 153(4) EPC

(43) Date of publication:
**30.10.2024 Bulletin 2024/44**

(21) Application number: **22911407.9**

(22) Date of filing: **23.12.2022**

(51) International Patent Classification (IPC):
*G09F 9/00* (2006.01)      *G09F 9/40* (2006.01)
*G02F 1/13* (2006.01)      *G02F 1/1334* (2006.01)

(52) Cooperative Patent Classification (CPC):
**G02F 1/13; G02F 1/1334; G09F 9/00; G09F 9/40**

(86) International application number:
**PCT/JP2022/047652**

(87) International publication number:
**WO 2023/120706 (29.06.2023 Gazette 2023/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **23.12.2021 JP 2021208959**

(71) Applicant: **Toppan Holdings Inc.**
**Tokyo 110-0016 (JP)**

(72) Inventors:
• **OONUMA Fumio**
  **Tokyo 110-0016 (JP)**
• **KANEKO Norihiko**
  **Tokyo 110-0016 (JP)**

(74) Representative: **Hoffmann Eitle**
**Patent- und Rechtsanwälte PartmbB**
**Arabellastraße 30**
**81925 München (DE)**

(54) **DISPLAY DEVICE**

(57)    A display device includes a transparent display that includes a front side displaying an image presented to a viewer, and a rear side facing away from the front side and through which the image is visible; a light control sheet that includes a light control layer containing a transparent polymer layer with a liquid crystal compound dispersed therein, the light control sheet being able to switch between a transparent state and an opaque state; and a control unit that controls the transparent state and the opaque state of the light control sheet. In the device, the distance between the rear side of the transparent display and a first surface of the light control sheet facing the rear side is 5 mm or more in air-equivalent length.

FIG.1

EP 4 456 048 A1

**Description**

[Technical Field]

The present disclosure relates to display devices.

[Background Art]

Transparent displays make the entire screen transparent when not displaying images and, when displaying images, the images are displayed with the backgrounds of the transparent displays visible therethrough. Depending on the background colors of transparent displays, images may be difficult to see. To address this, the transmissive display, i.e., transparent display, described in PTL 1 corrects displayed colors according to the background colors.

[Citation List]

[Patent Literature]

PTL 1: JP 2019-144508 A

[Summary of the Invention]

[Technical Problem]

When a typical transparent display is viewed from the rear side, which is opposite to the front side displaying an image, an image with left and right sides reversed relative to the image displayed on the front side is seen through the display and visible to the viewer. Accordingly, when a transparent display is used as a window or partition, etc., the viewer who can see the transparent display from the rear side can view the image on the transparent display from the rear side. Therefore, there is a need for display devices whose state can be switched by the users between a state in which an image is displayed with the background visible therethrough and a state in which the image is difficult to see from the rear side.

[Solution to Problem]

A display device for solving the above issues includes a transparent display that includes a front side displaying an image presented to a viewer, and a rear side facing away from the front side and through which the image is visible; and a light control sheet that includes a light control layer containing a transparent polymer layer with a liquid crystal compound dispersed therein, the light control sheet being able to switch between a transparent state and an opaque state, wherein a distance between the rear side of the transparent display and a first surface of the light control sheet facing the rear side is 5 mm or more in air-equivalent length.

The light control sheet containing a transparent polymer layer with a liquid crystal dispersed therein achieves an opaque state by becoming turbid in response to narrow angle scattered light, and therefore if the transparent display is brought into close contact with the light control sheet, the image on the transparent display is seen through the display and visible from the rear side of the light control sheet. According to the above configuration, since the distance between the rear side of the transparent display and the first surface of the light control sheet is 5 mm or more in air-equivalent length, light emitted from the rear side of the transparent display can be scattered between the transparent display and the light control sheet such that when viewed from the rear side the image is blurred. Accordingly, a first display state in which the image is displayed with the background visible therethrough can be switched to a second display state in which the image viewed from the rear side is blurred, or vice versa, so that the image can be displayed making use of the transparency of the transparent display, while maintaining confidentiality of the image and protecting privacy depending on the situation.

In the above display device, the distance between the rear side of the transparent display and the first surface of the light control sheet may be 50 mm or less in air-equivalent length.

According to the above configuration, since the distance between the rear side of the transparent display and the first surface of the light control sheet is 50 mm or less in air-equivalent length, the display device can maintain high transparency when the light control sheet is in the transparent state.

In the above display device, an air layer may be located between the rear side of the transparent display and the first surface of the light control sheet.

According to the above configuration, since the air layer is located between the transparent display and the light control sheet, the display device can be reduced in weight.

In the above display device, a transparent substrate may be located between the rear side of the transparent display and the first surface of the light control sheet.

According to the above configuration, since the transparent substrate is located between the transparent display and the light control sheet for support, the strength of the display device can be increased.

The above display device may include a semi-transparent mirror having a reflection surface and located between the rear side of the transparent display and the first surface of the light control sheet.

According to the above configuration, when the light control sheet is brought into the transparent state, the image can be blurred when viewed from the rear side, while maintaining transparency of the display device. Furthermore, by reflecting part of the light incident from the rear side of the display device, the image displayed on the display device and viewed from the front side can be made clearer.

In the above display device, the transparent substrate located between the rear side of the transparent display and the first surface of the light control sheet may be colored.

According to the above configuration, when the light control sheet is brought into the transparent state, the image can be blurred when viewed from the rear side, while maintaining transparency of the display device. Furthermore, since part of the light incident from the rear side can be absorbed by the colored transparent substrate, the image viewed from the front side can be made clearer.

In the above display device, the light control sheet may include the light control layer, two transparent electrode layers sandwiching the light control layer, and two transparent support layers sandwiching the light control layer and the two transparent electrode layers; the light control layer may contain the transparent polymer layer defining multiple voids therein, and the liquid crystal compound and a dichroic dye located in the voids; and alignment of the liquid crystal compound and the dichroic dye may be controlled according to a potential difference between the two transparent electrode layers.

According to the above configuration, since the light control layer contains a dichroic dye whose alignment is controlled together with the liquid crystal compound, concealability of the image when viewed from the rear side of the display device can be increased when the light control sheet is in the opaque state. Also, clarity of the image can be increased when viewed from the front side of the display device.

The above display device may further include a transparent support substrate that supports a second surface of the light control sheet facing away from the first surface.

According to the above configuration, since the second surface of the light control sheet is supported by the transparent support substrate, physical strength of the display device can be increased.

In the above display device, the light control sheet in the opaque state may have a haze of 85% or more.

In the above display device, the light control sheet in the opaque state may have a clarity of 60% or less.

In the above display device, the light control sheet in the opaque state may have a total light transmittance of 20% or less.

According to the above configuration, the effect of increasing blurring of the image can be enhanced due to the distance between the transparent display and the light control sheet being 5 mm or more in terms of air equivalent.

In the above display device, the light control sheet in the transparent state may have a total light transmittance of 40% or more.

According to the above configuration, the display device can enhance the effect of maintaining high transparency when the light control sheet is in the transparent state.

[Advantageous Effects of the Invention]

According to the present disclosure, a display device using a transparent display can switch a state in which the image is displayed with the background visible therethrough to a state in which the image is blurred when viewed from the rear side, or vice versa, to maintain confidentiality of the image and protect privacy.

[Brief Description of the Drawings]

Fig. 1 is a schematic diagram illustrating a display device viewed from the front side according to a first embodiment.
Fig. 2 is a cross-sectional view illustrating the display device according to the first embodiment.
Fig. 3 is a cross-sectional view illustrating a normal type light control sheet configuring the display device according to the first embodiment.
Fig. 4 is a cross-sectional view illustrating a reverse type light control sheet configuring the display device according to the first embodiment.

Fig. 5 is a cross-sectional view illustrating a display device according to a second embodiment.

Fig. 6 is a cross-sectional view illustrating part of a light control sheet according to a third embodiment.

Fig. 7 is a cross-sectional view illustrating a display device according to a fourth embodiment.

Fig. 8 is a cross-sectional view illustrating a display device according to a fifth embodiment.

Fig. 9 is a cross-sectional view illustrating a display device according to a sixth embodiment.

Fig. 10 is a plan view illustrating a light control sheet provided to a display device according to a seventh embodiment.

Fig. 11 is an operation diagram illustrating operation according to the seventh embodiment.

Fig. 12 is an operation diagram illustrating operation according to the seventh embodiment.

Fig. 13 is an operation diagram illustrating operation according to the seventh embodiment.

Fig. 14 is an operation diagram illustrating operation according to the seventh embodiment.

Fig. 15 is an operation diagram illustrating operation according to the seventh embodiment.

Fig. 16 is an operation diagram illustrating operation according to the seventh embodiment.

Fig. 17 is an operation diagram illustrating operation according to the seventh embodiment.

Fig. 18 is a device configuration diagram illustrating a light control sheet and a detection sheet provided to a display device according to an eighth embodiment.

Fig. 19 is a table showing evaluation results of display devices according to test examples and comparative examples.

Fig. 20 is a table showing evaluation results of display devices according to test examples and comparative examples.

Fig. 21 is a table showing evaluation results of display devices according to test examples and comparative examples.

[Description of the Embodiments]

(First Embodiment)

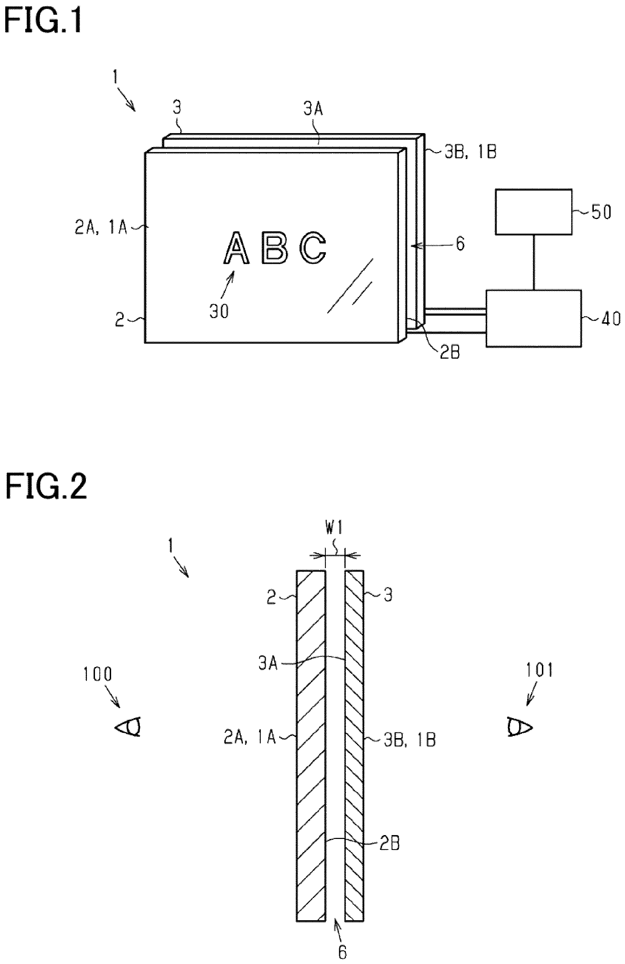

Referring to Figs. 1 to 4, a first embodiment of a display device will be described.

As shown in Fig. 1, a display device 1 includes a transparent display 2, a light control sheet 3, and a control device 40. The transparent display 2 has transparency and includes a front side 2A for displaying an image 30 presented to the viewer, and a rear side 2B located on an opposite side to the front side 2A. When the transparent display 2 is viewed from the front side 2A, the background of the transparent display 2 is seen through the transparent display 2 and is visible. The transparent display 2 may be, for example, a self-luminous organic EL display (OLED). The light control sheet 3 includes a first surface 3A facing the rear side 2B of the transparent display 2, and a second surface 3B located on an opposite side to the first surface 3A. The front side 2A of the transparent display 2 corresponds to a front side 1A of the display device 1, and the second surface 3B of the light control sheet 3 corresponds to a rear side 1B of the display device 1.

The light control sheet 3 is disposed such that a space 6 is provided between itself and the rear side 2B. The distance between the rear side 2B of the transparent display 2 and the first surface 3A of the light control sheet 3 is 5 mm or more in terms of air equivalent. The drive type of the light control sheet 3 may be normal or reverse. A normal type light control sheet 3 transitions its state from opaque to transparent with voltage application, and returns to opaque from transparent with release of voltage application. A reverse type light control sheet 3 transitions its state from transparent to opaque with voltage application, and returns to transparent from opaque with release of voltage application. Normal and reverse types are similar in that they are provided with two transparent electrode layers and a light control layer.

The transparent display 2 and the light control sheet 3 are connected to the control device 40. The control device 40 controls the voltage applied to the transparent display 2 to switch the display between a non-display state not displaying the image 30 and a display state displaying the image 30. The control device 40 controls the drive voltage applied to the control sheet 3 to switch the sheet between an opaque state and a transparent state. The control device 40 may be connected to an input operation device 50. The input operation device 50 is operated by the user to switch the transparent display 2 between the non-display state and the display state, and the light control sheet 3 between the transparent state and the opaque state. In other words, the input operation device 50 is operated by the user to switch the transparent display 2 between the non-display state and the display state. Also, the input operation device 50 is operated by the user to switch the light control sheet 3 between the transparent state and the opaque state.

Transparency of the light control sheet 3 can be expressed in terms of haze specified in JIS K 7136: 2000 "Plastics-Determination of haze for transparent materials". Haze can be expressed by a percentage of transmitted light that has passed through a specimen and deviated from the incident light by 2.5° or more. Haze of the light control sheet 3 in the opaque state may be 85% or more, and is more preferred to be 95% or more.

When the light control sheet 3 is in the opaque state, total light transmittance is 20% or less. Total light transmittance is a value measured using a method according to JIS K 7361-1: 1997 "Plastics - Determination of the total luminous transmittance of transparent materials - Part 1: Single beam instrument". When the light control sheet 3 is in the opaque state, total light transmittance is more preferred to be 10% or less. When the light control sheet 3 is in the transparent state, total light transmittance is 40% or more. When the light control sheet 3 is in the transparent state, total light transmittance is more preferred to be 50% or more. If the light control sheet 3 in the transparent state has a total light transmittance of 40% or more, the display device 1 can enhance the effect of maintaining high transparency when the light control sheet 3 is in the transparent state.

The light control sheet 3 in the opaque state has a clarity of 60% or less. Clarity herein refers to a degree at which an object image can be seen clearly and undistorted through the light control sheet 3, and can be expressed by the following Formula (1). Clarity can also be an index to evaluate whether the contour of an object image is clearly visible through the light control sheet 3.

$$100 \times \{(CL\text{-}LR)/(LC\text{+}LR)\} \qquad \dots (1)$$

The light intensity LC refers to the intensity of light traveling straight parallel to the light axis of parallel light, in the light that has passed through the light control sheet 3. The light intensity LR refers to the intensity of narrow angle scattered light whose angle to the light axis of parallel light is ±2.5°. If the light control sheet 3 is of a reverse type, the state of the light control sheet 3 in which AC voltage is applied between the two transparent electrode layers and haze is saturated is set to be opaque, as in the case of calculating haze.

When the light control sheet 3 is in the opaque state, the effect of increasing blurring of the image can be enhanced under conditions where haze, clarity, and total light transmittance of the light control sheet 3 satisfy the above ranges and the distance between the transparent display 2 and the light control sheet 3 is 5 mm or more in terms of air equivalent.

Fig. 2 shows a cross-sectional structure of the display device 1. There is the space 6 provided between the rear side 2B of the transparent display 2 and the first surface 3A of the light control sheet 3. If the light control sheet 3 is placed in close contact with the rear side 2B of the transparent display 2, there is a high probability that light emitted from the transparent display 2 will pass through the light control sheet 3 even when the light control sheet 3 is in the opaque state. Thus, when viewed from a viewer 101 facing the rear side 1B of the display device 1, the image projected on the transparent display 2 is seen through the display and visible to the viewer 101. In particular, if the light incident on the light control sheet 3 is narrow angle scattered light, this tendency is prominent.

In this regard, the display device 1 is provided with the space 6 between the rear side 2B of the transparent display 2 and the first surface 3A of the light control sheet 3, so that the light emitted from the rear side 2B of the transparent display 2 is scattered. The space 6 is an air layer, and the light incident on the space 6 is scattered therein. Therefore, when the image 30 displayed on the transparent display 2 is viewed from the rear side, the image 30 becomes blurred.

The space 6 has a width W1 of 5 mm or more. In other words, the relative distance between the transparent display 2 and the light control sheet 3 is 5 mm or more. Specifically, the distance between the transparent display 2 and the light control sheet 3 is 5 mm or more in air-equivalent length LA. The air-equivalent length LA can be calculated from the following formula.

$$LA = T + T \times (1\text{-}1/n)$$

In the above formula, T is a thickness of a medium located between the rear side 2B of the transparent display 2 and the first surface 3A of the light control sheet 3, and n is a refractive index of the medium. In the present embodiment, there is air present between the rear side 2B of the transparent display 2 and the first surface 3A of the light control sheet 3. Since the refractive index n of air is 1, the distance between the rear side 2B of the transparent display 2 and the first surface 3A of the light control sheet 3 in the present embodiment is equal to the air-equivalent length LA.

If the space 6 is filled with only one medium, the thickness T matches the distance between the rear side 2B of the transparent display 2 and the first surface 3A of the light control sheet 3. However, if the space 6 is filled with two media, for example, the air-equivalent length LA is the sum of the air-equivalent length calculated using the above formula for the first medium, and the air-equivalent length calculated using the above formula for the second medium. For example, if there are an air layer and a substrate layer between the rear side 2B of the transparent display 2 and the first surface 3A of the light control sheet 3, the sum of the thickness of the air layer and the thickness of the substrate layer in air-equivalent length is the distance between the rear side 2B and the first surface 3A in air-equivalent length.

With the width W1 being 5 mm or more, the image viewed from the rear side 1B can be blurred when the light control sheet 3 is in the opaque state. With the lower limit of the width W1 being 10 mm or more, the image viewed from the rear side 1B can be blurred further when the light control sheet 3 is in the opaque state, and concealability of the image 30 can be enhanced. The width W1 of the space 6 is 50 mm or less. With the width W1 exceeding 50 mm, transparency of the display device 1 is reduced when the light control sheet 3 is in the transparent state. Specifically, with the width W1 being 50 mm or less, transparency of the display device 1 is prevented from being reduced when the light control sheet 3 is in the transparent state. More specifically, with the width W1 being 50 mm or less, haze of the display device 1 is prevented from increasing when the light control sheet 3 is in the transparent state.

From the perspective of increasing blurring of the image viewed from the rear side 1B when the light control sheet 3 is opaque and increasing transparency of the display device 1 when the light control sheet 3 is transparent, the distance between the transparent display 2 and the light control sheet 3 is preferred to be 5 mm or more and 20 mm or less, and more preferred to be 5 mm or more and 10 mm or less.

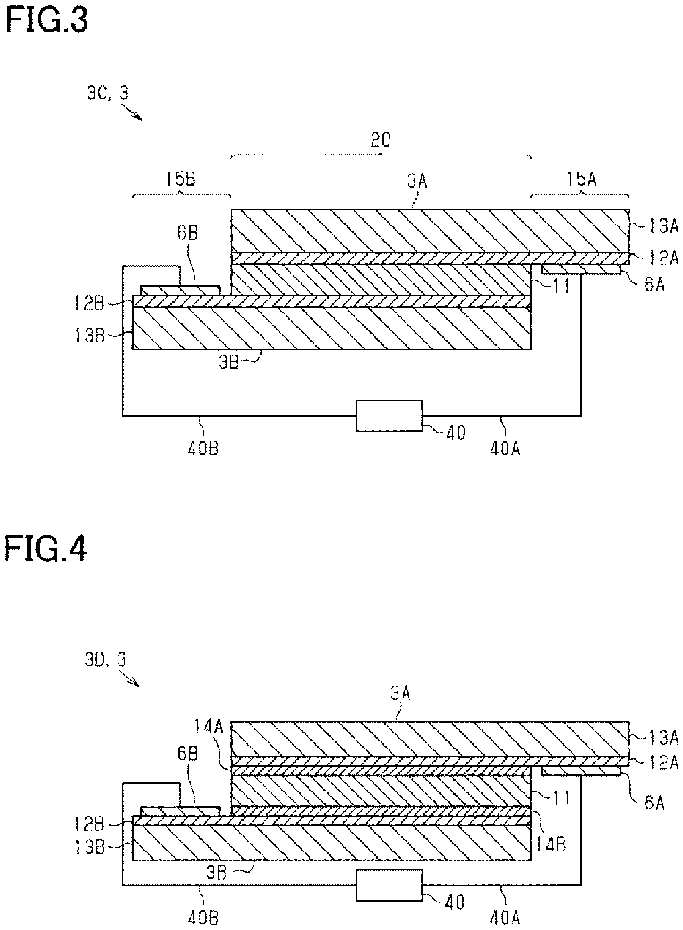

Referring to Figs. 3 and 4, the cross-sectional structure of the light control sheet 3 will be described. It should be noted that the thickness ratio between the layers shown in the cross-sectional view of the light control sheet 3 is shown only for convenience of explanation. Therefore, the thickness ratio between the layers of the light control sheet 3 is not limited to the thickness ratios shown in Figs. 3 and 4.

Fig. 3 shows a cross-sectional structure of a normal type light control sheet 3C. The light control sheet 3C includes a light control layer 11, a first transparent electrode layer 12A, a second transparent electrode layer 12B, a first transparent support layer 13A, and a second transparent support layer 13B. The light control layer 11 is sandwiched between the first and second transparent electrode layers 12A and 12B.

The light control sheet 3C is provided with a first connection area 15A and a second connection area 15B. In addition to the first and second connection areas 15A and 15B, the light control sheet 3C is provided with a light control area 20. In the light control sheet 3C, the first connection area 15A does not include the light control layer 11, the second transparent electrode layer 12B, and the second transparent support layer 13B. The first transparent electrode layer 12A is exposed in the first connection area 15A. A first terminal 6A is connected to the first transparent electrode layer 12A exposed in the first connection area 15A.

In the light control sheet 3C, the second connection area 15B does not include the light control layer 11, the first transparent electrode layer 12A, and the first transparent support layer 13A. The second transparent electrode layer 12B is exposed in the second connection area 15B. A second terminal 6B is connected to the second transparent electrode layer 12B exposed in the second connection area 15B.

In the light control sheet 3C, the light control area 20 is a portion excluding the first and second connection areas 15A and 15B. Specifically, in the light control sheet 3C, the light control area 20 is a portion including the light control layer 11.

The terminals 6A and 6B are electrically connected to the control device 40 via wirings 40A and 40B. The first terminal 6A is connected to the control device 40 via the wiring 40A, and the second terminal 6B is connected to the control device 40 via the wiring 40B. The control device 40 applies an AC voltage to the light control area 20. The control device 40 generates a drive voltage signal for changing light transmittance, or specifically, diffuse transmittance, and applies the signal to the first and second terminals 6A and 6B. Thus, the control device 40 controls the potential difference between the first and second transparent electrode layers 12A and 12B in the light control area 20. The second transparent electrode layer 12B is controlled to have a ground potential, for example.

In the light control layer 11, a liquid crystal compound is dispersed in a transparent polymer. The light control layer 11 contains a transparent polymer layer that is a resin composition, a liquid crystal composition, and spacers, not shown. The transparent polymer layer is a cured product of a photopolymerizable compound. The photopolymerizable compound may be a UV curable compound or an electron beam curable compound. Photopolymerizable compounds are compatible with liquid crystal compositions. The transparent polymer layer defines voids in the light control layer 11. The liquid crystal composition contains a liquid crystal compound and fills the voids of the transparent polymer layer. The voids may have two or more sizes. Specifically, the multiple voids may include voids having a first size and voids having a second size different from the first size. The shape of the voids can be spherical, ellipsoidal, or irregularly shaped. If dimensional controllability of the voids is required to be enhanced, the photopolymerizable compound is preferred to be a UV curable compound. The spacers are interposed between the first and second transparent electrode layers 12A and 12B to uniform the height, i.e., the thickness, of the light control layer 11.

The retention type of the liquid crystal composition can be one of a polymer network type, a polymer dispersion type, and a capsule type. The polymer network type has a three-dimensional mesh transparent polymer network, and retains a liquid crystal composition in the mesh voids communicating with each other. The polymer network is an example of a transparent polymer layer. The polymer dispersion type has a large number of isolated voids in a transparent polymer layer, and retains a liquid crystal composition in the voids dispersed in the polymer layer. The capsule type retains a liquid crystal composition with a capsule shape in a transparent polymer layer. The light control layer 11 may have a thickness of 0.5 $\mu$m or more and 460 $\mu$m or less. In particular, the thickness of light control layer 11 is preferred to be 1 $\mu$m or more and 100 $\mu$m or less, and more preferred to be 3 $\mu$m or more and 50 $\mu$m or less.

The first and second transparent electrode layers 12A and 12B are electrically conductive and transparent to light in the visible region. The first and second transparent electrode layers 12A and 12B may be made of known materials. Examples of the materials for forming the first and second transparent electrode layers 12A and 12B include indium tin oxide, fluorine-doped tin oxide, tin oxide, zinc oxide, carbon nanotubes, and poly(3,4-ethylenedioxythiophene). The first and second transparent electrode layers 12A and 12B may each have a thickness, for example, of 5 nm or more and 500 nm or less.

The first and second transparent support layers 13A and 13B are substrates transparent to light in the visible region. The first and second transparent support layers 13A and 13B can be made of known materials. One example of the materials for forming the first and second transparent support layers 13A and 13B may be a synthetic resin or inorganic compound. Examples of the synthetic resin include polyesters, polyacrylates, polycarbonates, and polyolefins. Examples of the polyesters include polyethylene terephthalate and polyethylene naphthalate. Examples of the polyacrylates include polymethylmethacrylate. Examples of the inorganic compound include silicon dioxide, silicon oxynitride, and silicon nitride. The first and second transparent support layers 13A and 13B may each have a thickness, for example, of 20 $\mu$m or more and 500 $\mu$m or less.

The first and second terminals 6A and 6B each include, for example, a conductive adhesive layer and a wiring substrate. The conductive adhesive layer may be formed of, for example, an anisotropic conductive film (ACF), anisotropic conductive paste (ACP), isotropic conductive film (ICF), isotropic conductive paste (ICP), or the like. The wiring substrate may be, for example, a flexible printed circuit (FPC) board. Alternatively, the first and second terminals 6A and 6B may each have a structure in which a conductive material such as a conductive tape is solder-bonded to the respective wiring 40A or 40B.

The light control layer 11 changes alignment of the liquid crystal compound in response to voltage changes caused between the first and second transparent electrode layers 12A and 12B. Alignment change in the liquid crystal compound changes the degree of scattering, the degree of absorption, and the degree of transmission of visible light entering the light control layer 11. Specifically, when no voltage signal is applied to the first and second transparent electrode layers 12A and 12B, orientations of the long axes of the molecules of the liquid crystal compound are irregular. Accordingly, the degree of scattering of light incident on the light control layer 11 increases, whereby the light control area 20 is brought into the opaque state in which it appears to be turbid. However, when the voltage signal is applied, a potential difference of a predetermined value or more is caused between the first and second transparent electrode layers 12A and 12B, and the liquid crystal compound is aligned, whereby the long axes of the molecules of the liquid crystal compound are aligned parallel to the direction of the electric field between the first and second transparent electrode layers 12A and 12B. Specifically, the direction of the long axes of the molecules of the liquid crystal compound becomes substantially perpendicular to the planes in which the first and second transparent electrode layers 12A and 12B extend. Consequently, since light is easily transmitted through the light control layer 11, the light control area 20 is brought into the transparent state.

Fig. 4 shows a cross-sectional structure of a reverse type light control sheet 3D. The reverse type light control sheet 3D is different from the normal type light control sheet 3C in that it includes a first alignment layer 14A between the light control layer 11 and the first transparent electrode layer 12A, and a second alignment layer 14B between the light control layer 11 and the second transparent electrode layer 12B. The liquid crystal composition contained in the light control layer 11 contains a negative type liquid crystal compound with a negative dielectric constant.

When application of the drive voltage to the first and second transparent electrode layers 12A and 12B is stopped, the liquid crystal compound is subjected to an alignment regulating force from the first and second alignment layers 14A and 14B, whereby the long axes of the molecules of the liquid crystal compound are made parallel to the lamination direction in the light control sheet 3D. Specifically, the long axes of the molecules become substantially perpendicular to the planes in which the first and second alignment layers 14A and 14B of the liquid crystal compound extend. Thus, the light control sheet 3D prevents light scattering in the light control layer 11 throughout the visible light range, and is brought into the transparent state.

With the start of drive voltage application, the liquid crystal compound is subjected to the alignment regulating force of the electric field. The long axes of the molecules of the liquid crystal compound start to move in the direction perpendicular to the electric field direction. In this case, the long axes of the molecules of the liquid crystal compound are restricted in direction by the interaction between the molecules of the liquid crystal composition and the size of voids; however, are aligned such that light incident on the light control sheet 3 is scattered. Thus, the light control sheet 3D causes light scattering in the light control layer 11 throughout the visible light range, and is brought into the opaque state.

Next, referring to Fig. 2, operation of the display device 1 will be described. Operation of the display device 1 herein is described assuming that the light control sheet 3 is of a reverse type. The display device 1 switches between the non-display state not displaying the image 30 and the display state displaying the image 30. As the non-display state, the display device 1 has a first non-display state in which the light control sheet 3 is in the transparent state and a second non-display state in which the light control sheet 3 is in the opaque state. As the display state, the display device 1 has a first display state in which the image is seen through from the rear side 1B and a second display state in which the image 30 viewed from the rear side 1B has low visibility. In other words, the display device 1 has four modes.

(First non-display state)

The non-display state will be described. In the first non-display state, the control device 40 does not apply the drive voltage for displaying the image 30 on the transparent display 2 by which the transparent display 2 is in an off state, and does not apply the drive voltage to the light control sheet 3 by which the light control sheet 3 is in the transparent state. In the first non-display state, power consumption of the display device 1 is the smallest of the four modes. In this case, when viewed from a viewer 100 facing the front side 1A of the display device 1, objects such as people located beyond the rear side 1B are visible. Similarly, when viewed from a viewer 101 facing the rear side 1B, objects such as the viewer 100 facing the front side 1A are visible. In the first non-display state, transparency of the display device 1 is increased by which the space where the display device 1 is installed can feel less confined. In other words, in the non-display state of the display device 1, the display device 1 can function as a window or partition having high transparency.

(Second non-display state)

In the second non-display state, the control device 40 does not apply the drive voltage for displaying the image 30 on the transparent display 2 by which the transparent display 2 is in an off state, but applies the drive voltage to the light control sheet 3 by which the light control sheet 3 is in the opaque state. In the second non-display state in which the light control sheet 3 is in the opaque state, objects such as the viewer 101 located beyond the rear side 1B are less likely to be visible when viewed from the viewer 100 facing the front side 1A of the display device 1, compared to the case where the display device 1 is in the first non-display state. Also, objects such as the viewer 100 facing the front side 1A are less likely to be visible when viewed from the viewer 101 facing the rear side 1B, compared to the case where the display device 1 is in the first non-display state. In the second non-display state, maintaining confidentiality and protection of privacy can be improved in the spaces defined by the display device 1 even when no image 30 is displayed.

(First display state)

In the first display state, the control device 40 applies the drive voltage to the transparent display 2 by which the image 30 is displayed on the transparent display 2, but does not apply the drive voltage to the light control sheet 3 by which the light control sheet 3 is in the transparent state. For information not requiring privacy protection, etc., objects located behind the rear side may be deliberately allowed to be seen through the display. In the first display state, the viewer 100 facing the front side 1A of the display device 1 can view the image 30 overlapped with the background. The viewer 101 facing the rear side 1B of the display device 1 views the image 30 displayed on the transparent display 2 in an inverted state relative to the image 30 viewed from the front side 1A. In the first display state, the display device 1 can display the image 30 with the transparency thereof increased by which the space where the display device 1 is installed can feel less confined. In other words, in the first display state of the display device 1, the display device 1 can function as a window or partition having high transparency.

(Second display state)

In the second display state, the control device 40 applies the drive voltage to the transparent display 2 by which the image 30 is displayed on the transparent display 2, and applies the drive voltage to the light control sheet 3 by which the light control sheet 3 is in the opaque state. With the application of the drive voltage, the light control sheet 3 becomes turbid, and is resultantly brought into the opaque state. The viewer 100 facing the front side 1A of the display device 1 views the image 30 displayed on the transparent display 2. The viewer 101 facing the rear side 1B of the display device 1 can view the image 30 with only low visibility or cannot view the image 30. Thus, confidentiality of the displayed image 30 can be maintained, thereby protecting privacy. The light control sheet 3 in the opaque state reduces the intensity of the light incident on the transparent display from the rear side 1B of the display device 1, and therefore the viewer 100 facing the front side 1A can view a clear image 30.

In the first and second display states, the intensity of the light incident on the transparent display 2 via the light control sheet 3 can be reduced due to the presence of the space 6, and therefore clarity of the image 30 viewed from the front side 1A can be improved.

Thus, the display device 1, which can switch between the non-display states and between the display states depending on usage, is effective in particular when used as windows or partitions of buildings, or windows of mobile objects such as automobiles.

As described above, according to the first embodiment of the display device, the following effects can be achieved.

(1-1) Since the distance between the rear side 2B of the transparent display 2 and the first surface 3A of the light control sheet 3 is 5 mm or more in air-equivalent length, the light incident on the rear side 2B of the transparent display 2 can be scattered between the transparent display 2 and the light control sheet 3 such that the image 30 is blurred when viewed from the rear side 1B. Furthermore, since the first display state in which the image 30 is displayed with the background visible therethrough can be switched to the second display state in which the image 30 viewed from the rear side 1B is blurred, or vice versa, the image 30 can be displayed making use of the transparency of the transparent display 2, while maintaining confidentiality of the image 30 and protecting privacy depending on the situation.

(1-2) Since the distance between the rear side 2B of the transparent display 2 and the first surface 3A of the light control sheet 3 is 50 mm or less in air-equivalent length, the display device 1 can maintain high transparency in the first non-display state and the first display state in which the light control sheet 3 is in the transparent state.

(1-3) Since the space 6, i.e., an air layer, is located between the transparent display 2 and the light control sheet 3, the display device 1 can be reduced in weight.

(1-4) Since the light control sheet 3 in the opaque state has a haze of 95% or more, the image 30 can be blurred when viewed from the rear side 1B of the display device 1 in the second display state.

(1-5) Since the light control sheet 3 in the opaque state has a clarity of 60% or less, the image 30 can be blurred when viewed from the rear side 1B of the display device 1 in the second display state.

(1-6) Since the light control sheet 3 in the opaque state has a total light transmittance of 20% or less, the image 30 can be blurred when viewed from the rear side 1B of the display device 1 in the second display state.

(1-7) Since the light control sheet 3 in the transparent state has a total light transmittance of 40% or more, the light control sheet 3 can be transparent, and the display device 1 can maintain high transparency in the non-display state in which the image 30 is not displayed and in the first display state in which the image is seen through from the rear side 1B.

(Second Embodiment)

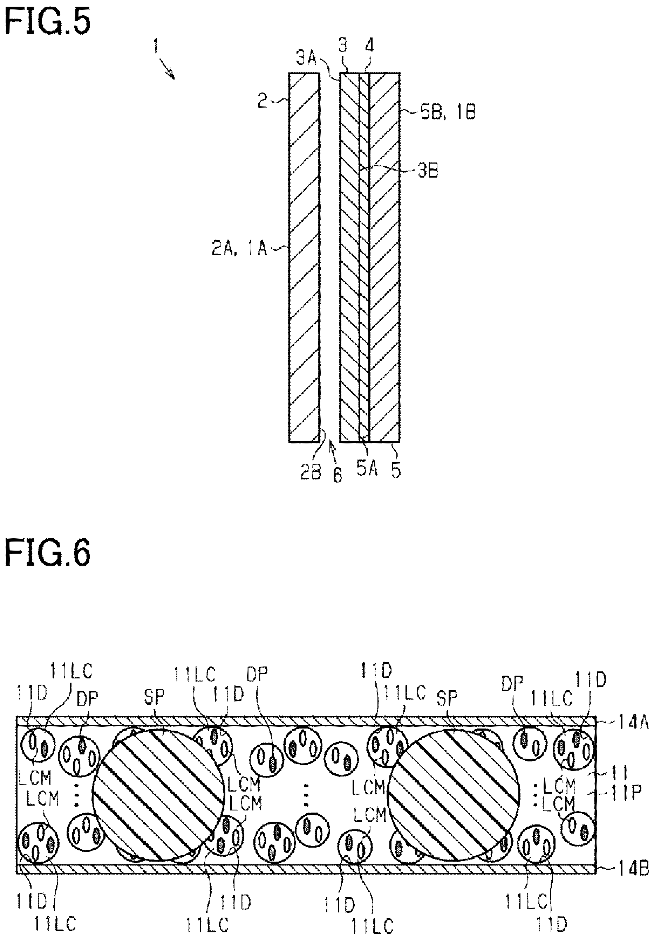

Referring to Fig. 5, a second embodiment of a display device will be described.

A display device 1 according to the second embodiment includes a transparent adhesive layer 4 and a transparent support substrate 5, in addition to the configuration of the display device 1 according to the first embodiment. The transparent adhesive layer 4 is provided to the second surface 3B of the light control sheet 3, so that the transparent support substrate 5 can be bonded to the light control sheet 3. The transparent adhesive layer 4 may have at least one of the following properties which are UV scattering, UV absorption, infrared scattering, infrared absorption, and sound insulation.

The transparent support substrate 5 includes a first surface 5A bonded to the transparent adhesive layer 4 and a second surface 5B facing away from the first surface 5A. The transparent support substrate 5 supports the light control sheet 3 via the transparent adhesive layer 4. The transparent support substrate 5 supports the second surface 3B of the light control sheet 3. The second surface 5B of the transparent support substrate 5 corresponds to the rear side 1B of the display device 1. The transparent support substrate 5 may have a single-layer structure or a multilayer structure. The transparent support substrate 5 may have at least one of the following properties which are UV scattering, UV absorption, infrared scattering, infrared absorption, scratch resistance, moisture penetration protection, and anti-reflectivity.

As described above, according to the second embodiment, the following effects can be achieved in addition to the effects (1-1) to (1-7) of the first embodiment.

(2-1) Since the display device 1 includes the transparent support substrate 5 for supporting the light control sheet 3, physical strength of the display device 1 can be increased.

(Third Embodiment)

Referring to Fig. 6, a third embodiment of the display device 1 will be described. In the third embodiment, the light control sheet 3 includes a light control layer 11 containing a dichroic dye.

Fig. 6 shows a cross section of part of a reverse type light control sheet 3, including cross sections of the light control layer 11 of a PDLC (polymer dispersed liquid crystal) type, and alignment layers 14A and 14B. The light control sheet 3 may be of a normal type. The retention type of the liquid crystal composition in the light control layer 11 may be of a PNLC (polymer network liquid crystal) type in which the liquid crystal compound is dispersed in a mesh polymer layer.

The light control layer 11 contains a transparent polymer layer 11P, a liquid crystal composition 11LC, and spacers SP. The transparent polymer layer 11P is a cured product of a photopolymerizable compound. The photopolymerizable compound may be a UV curable compound or an electron beam curable compound. The photopolymerizable compound is compatible with the liquid crystal composition 11LC.

The transparent polymer layer 11P defines voids 11D in the light control layer 11. The transparent polymer layer 11P contains multiple voids 11D. If dimensional controllability of the voids 11D is required to be improved, the photopolymerizable compound is preferred to be a UV curable compound. An example of the UV curable compound may contain polymerizable unsaturated bonds at the ends of the molecule structure. Alternatively, the UV curable compound may contain polymerizable unsaturated bonds at positions other than the ends of the molecule structure. The photopolymerizable compound may be a single polymerizable compound or may be a combination of two or more polymerizable compounds. The liquid crystal composition 11LC fills the voids 11D of the transparent polymer layer 11P.

The liquid crystal composition 11LC contains a liquid crystal compound LCM and a dichroic dye DP. The liquid crystal composition 11LC may further contain a viscosity reducer, antifoamer, antioxidant, weatherproof agent, and solvent. An example of the weatherproof agent may be a UV absorber or light stabilizer.

The retention type of the transparent polymer layer 11P for the liquid crystal composition 11LC may be the PDLC type or the PNLC type mentioned above, or a capsule type. The retention type for the liquid crystal composition 11LC may be any type from the group consisting of PDCL type, PNCL type, and capsule type.

The transparent polymer layer 11P of a PNLC type light control layer 11 includes multiple voids 11D defined by a three-dimensional mesh. The liquid crystal composition 11LC is located inside the mesh voids 11D communicating with each other. The transparent polymer layer 11P of a capsule type light control layer 11 includes dispersed capsule-like voids 11D, and the liquid crystal composition 11LC is located inside the voids 11D. The voids 11D may have two or more sizes. Specifically, the multiple voids 11D may include voids 11D with a first size and voids 11D with a second size different from the first size. The shape of the voids 11D can be spherical, ellipsoidal, or irregularly shaped.

The liquid crystal compound LCM is at least one selected from the group consisting of Schiff base compounds, azo compounds, azoxy compounds, biphenyl compounds, terphenyl compounds, benzoic acid ester compounds, tolan compounds, pyrimidine compounds, pyridazine compounds, cyclohexanecarboxylic acid ester compounds, phenylcyclohexane compounds, biphenylcyclohexane compounds, dicyanobenzene compounds, naphthalene compounds, and dioxane compounds. The liquid crystal compound LCM may be a single liquid crystal compound or may be a combination of two or more liquid crystal compounds.

Molecules of the dichroic dye DP each have an elongated shape, and light absorbance in the visible region in the molecular long-axis direction is higher than the light absorbance in the molecular short-axis direction. The dichroic dye DP of the present embodiment is black or a color close to black in the state in which the molecular long-axis direction intersects at a predetermined angle with the light incidence direction. Specifically, the dichroic dye DP is black or a color close to black when the molecules are at least aligned such that the molecular long-axis direction is substantially orthogonal to the normal direction to the surface of the light control layer 11 contacting the alignment layer 14A or the surface thereof contacting the alignment layer 14B. The dichroic dye DP is driven with a host-guest system using the liquid crystal compound LCM as a host, and thereby develops a color. The dichroic dye DP may develop a color other than black.

The dichroic dye DP is at least one selected from the group consisting of polyiodine, azo compounds, anthraquinone compounds, naphthoquinone compounds, azomethine compounds, tetrazine compounds, quinophthalone compounds, merocyanine compounds, perylene compounds, and dioxazine compounds. The dichroic dye DP may be a single dye or may be a combination of two or more dyes. If light resistance and dichroic ratio are required to be increased, the dichroic dye is preferred to be at least one selected from the group consisting of azo compounds and anthraquinone compounds, and more preferred to be an azo compound.

Content of the dichroic dye DP is preferred to be 0.5 wt% or more and 10 wt% or less, and more preferred to be 1 wt% or more and 5 wt% or less relative to the total weight of the light control layer 11. With the content of the dichroic dye DP being 0.5 wt% or more, the image viewed from the rear side 1B of the display device 1 can be blurred when the light control sheet 3 is in the opaque state. With the content of the dichroic dye DP being 1 wt% or more, the image viewed from the rear side 1B of the display device 1 can be blurred further when the light control sheet 3 is in the opaque state.

The spacers SP are dispersed throughout the transparent polymer layer 11P The spacers SP determine the thickness of the light control layer 11 in the vicinities of the spacers SP, and uniform the thickness of the light control layer 11. The spacers SP may be bead spacers or may be photo spacers formed by exposure and development of a photo resist. The spacers SP may be translucent, colorless or colored. The color of the colored transparent spacers SP is preferred to be the same as the color developed by the dichroic dye DP.

The control device 40 applies the drive voltage to the first and second transparent electrode layers 12A and 12B to cause a potential difference therebetween, according to which, alignment of the liquid crystal compound LCM and the dichroic dye DP is controlled. The drive voltage changes the alignment state of the liquid crystal compound LCM and the dichroic dye DP.

During release of drive voltage application, the liquid crystal compound LCM is subjected to the alignment regulating force, whereby the long-axis direction of the molecules of the liquid crystal compound LCM and the dichroic dye DP becomes substantially parallel to the normal direction to the alignment layers 14A and 14B. Thus, diffuse light transmittance of the light control sheet 3 becomes higher than in the opaque state, and therefore haze becomes lower than in the opaque state. Also, the light control sheet 3 becomes colorless or nearly colorless.

During drive voltage application, the long-axis direction of the molecules of the liquid crystal compound LCM and the dichroic dye DP follows the electric field in the scattering manner of incident light on the light control sheet 3, whereby the light control sheet 3 is brought into the opaque state. Of the molecules of the dichroic dye DP, those which have angles near 90° as small angles relative to the normal direction to the alignment layers 14A and 14B develop a black color. Due to the presence of the space 6 between the transparent display 2 and the light control sheet 3, and, in addition, due to the light control sheet 3 in the opaque state developing a black color, the image can be blurred when viewed from the rear side 1B of the display device 1.

As described above, according to the third embodiment, the following effects can be achieved in addition to the effects (1-1) to (1-7) of the first embodiment.

(3-1) The light control layer 11 contains the liquid crystal compound LCM and the dichroic dye DP and is driven with a host-guest system. Therefore, during drive voltage application between the first and second transparent electrode layers 12A and 12B, the reverse type light control sheet 3 is brought into a colored opaque state, so that concealability of the image is increased when viewed from the rear side 1B of the display device 1. Furthermore, if the light control layer 11 contains a dichroic dye DP developing a black color, the dichroic dye DP absorbs visible light incident from the rear side 1B of the display device 1, and therefore the viewer 100 can view a clear image from the front side 1A of the display device 1.

(Fourth Embodiment)

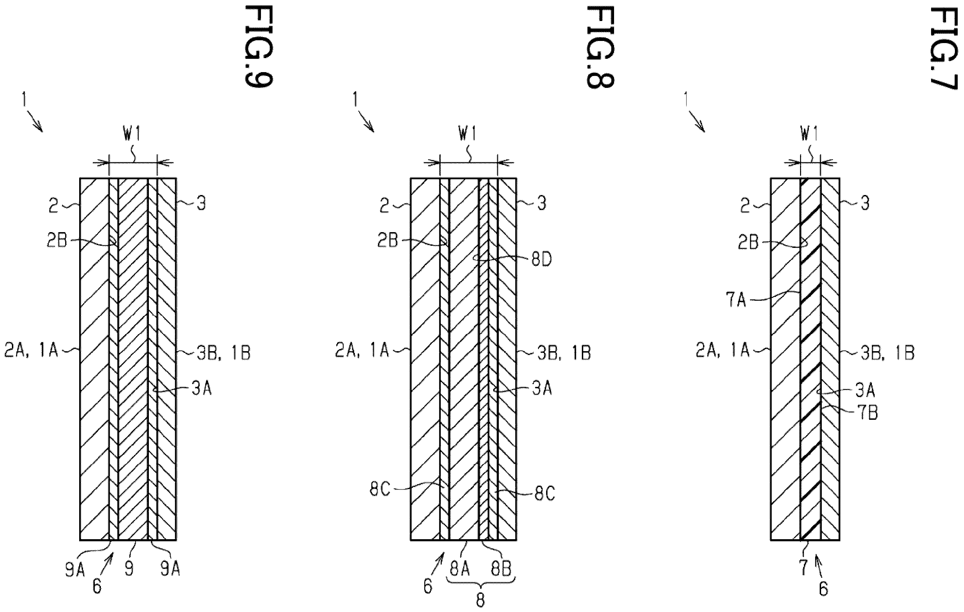

Referring to Fig. 7, a fourth embodiment of a display device will be described.

A display device 1 includes a transparent substrate 7 between the transparent display 2 and the light control sheet 3. In other words, the transparent substrate 7 is located in a space 6 between the transparent display 2 and the light control sheet 3.

If the full capacity of the space 6 is occupied by the transparent substrate 7, the thickness of the transparent substrate 7 is 5 mm or more in air-equivalent length. This is a value calculated through air conversion of the thickness of the transparent substrate 7. As mentioned above, the air-equivalent length LA of the transparent substrate 7 can be calculated based on the thickness and refractive index of the transparent substrate 7. The refractive index of the transparent substrate 7 is larger than 1 that is the refractive index of air. Accordingly, the air-equivalent length LA of the transparent substrate 7 is larger than the thickness of the transparent substrate 7.

The transparent substrate 7 has a first surface 7A and a second surface 7B facing away from the first surface. The first surface 7A supports the rear side 2B of the transparent display 2, and the second surface 7B supports the first surface 3A of the light control sheet 3. An adhesive layer may be provided at least between the transparent display 2 and the transparent substrate 7 or between the transparent substrate 7 and the light control sheet 3. Specifically, an adhesive layer may be located between the transparent display 2 and the transparent substrate 7 and/or between the transparent substrate 7 and the light control sheet 3. Alternatively, the transparent display 2 and the transparent substrate 7 may be in contact with each other with no adhesive layer provided therebetween, and the transparent substrate 7 and the light control sheet 3 may be in contact with each other with no adhesive layer provided therebetween. Alternatively, the transparent substrate 7 may occupy only part of the space 6. In other words, air layer(s) and the transparent substrate 7 may be located between the transparent display 2 and the light control sheet 3. In this case, the transparent substrate 7 may be in contact with the transparent display 2 or the light control sheet 3, or may be separated from both of the transparent display 2 and the light control sheet 3.

Examples of the material used for forming the transparent substrate 7 include resin materials such as acrylic resins, polycarbonates (PC), polyethylene terephthalate (PET), polyvinyl chlorides (PVC), and polyimides (PI), and glass. An example of the acrylic resins may be PMMA. The transparent substrate 7 may have a single-layer structure made of one material, or may have a laminated structure including multiple layers made of different materials. Specifically, the transparent substrate 7, if it has a laminated structure, may include a first layer formed of a first material and a second layer formed of a second material different from the first material. The transparent substrate 7 may be colorless and transparent or may be colored and transparent.

The refractive index of the transparent substrate 7 may be higher than that of the transparent display 2. The refractive index of the transparent display 2 corresponds to the refractive index configuring the outermost layer of the transparent display 2. The refractive index of the transparent substrate 7 may be equal to or lower than that of the transparent display 2.

As described above, according to the fourth embodiment, the following effects can be achieved in addition to the effects (1-1) to (1-7) of the first embodiment.

(4-1) Since the transparent substrate 7 is located between the transparent display 2 and the light control sheet 3 for support, the strength of the display device 1 can be increased.

(Fifth Embodiment)

Referring to Fig. 8, a fifth embodiment of a display device will be described.

A display device 1 according to the present embodiment includes a semi-transparent mirror 8 in place of the transparent substrate 7 of the fourth embodiment. The semi-transparent mirror 8 is located between the transparent display 2 and the light control sheet 3. A transparent adhesive layer 8C is located between the semi-transparent mirror 8 and the transparent display 2 and another transparent adhesive layer 8C is located between the semi-transparent mirror 8 and the light control sheet 3. The transparent adhesive layers 8C are made of a transparent adhesive material. A first transparent adhesive layer 8C bonds the semi-transparent mirror 8 to the transparent display 2, and a second transparent adhesive layer 8C bonds the semi-transparent mirror 8 to the light control sheet 3. If each layer can be supported without an adhesive material, the transparent adhesive layers 8C may be omitted. Specifically, if the semi-transparent mirror 8 can be bonded to the transparent display without using an adhesive material, the first transparent adhesive layer 8C may be omitted. Also, if the semi-transparent mirror 8 can be bonded to the light control sheet 3 without using an adhesive material, the second transparent adhesive layer 8C may be omitted.

The semi-transparent mirror 8 is configured such that part of visible light is reflected and the rest is transmitted. In the semi-transparent mirror 8, a metal film 8B with a predetermined thickness is laminated on a transparent substrate 8A. The transparent substrate 8A may be similar to the transparent substrate 7 of the fourth embodiment. The material forming the metal film 8B can be at least one of aluminum, silver, and gold. The semi-transparent mirror 8 has a reflection surface 8D on which the metal film 8B is provided, and the reflection surface 8D may be opposed to the light control sheet 3 via the transparent adhesive layer 8C. In other words, the semi-transparent mirror 8 is provided with the reflection surface 8D. The reflection surface 8D corresponds to the surface of the transparent substrate 8A on which the metal film 8B is located. Alternatively, the reflection surface 8D may be opposed to the transparent display 2 via the transparent adhesive layer 8C. The semi-transparent mirror 8 may include a transparent substrate and a metal film, and the metal film may be affixed to the transparent substrate.

If the semi-transparent mirror 8 is interposed between the transparent display 2 and the light control sheet 3, part of the light emitted from the rear side 2B of the transparent display 2 is reflected by the reflection surface 8D of the semi-transparent mirror 8. Also, part of the light entered via the light control sheet 3 is reflected. Thus, the image displayed on the transparent display 2 is prevented from being seen through and, in addition, light is prevented from being incident on the rear side of the transparent display 2, and therefore the image can be made clearer when viewed from the front side 1A of the display device 1.

As described above, according to the fifth embodiment, the following effects can be achieved in addition to the effects (1-1) to (1-7) of the first embodiment and the effect (4-1) of the fourth embodiment.

(5-1) Since the semi-transparent mirror 8 is located between the transparent display 2 and the light control sheet 3, when the light control sheet 3 is brought into the transparent state, transparency of the display device 1 can be maintained and at the same time the image can be blurred when viewed from the rear side 1B. Furthermore, by reflecting part of the light incident from the rear side 1B of the display device 1 at the reflection surface 8D, the image 30 displayed on the display device 1 and viewed from the front side 1A can be made clearer.


(Sixth embodiment)

Referring to Fig. 9, a sixth embodiment of a display device will be described. A display device 1 according to the present embodiment includes a colored transparent substrate 9 in place of the transparent substrate 7 of the fourth embodiment. The colored transparent substrate 9 is located between the transparent display 2 and the light control sheet 3.

The colored transparent substrate 9 may be obtained by adding a dye to glass or a transparent resin. Alternatively, the colored transparent substrate 9 may be obtained by affixing a colored film to a transparent substrate. For example, the colored transparent substrate 9 may be smoked glass. The colored transparent substrate 9 may be opposed to the transparent display 2 and the light control sheet 3 via respective transparent adhesive layers 9A. Specifically, the colored transparent substrate 9 may be affixed to the transparent display 2 via a first transparent adhesive layer 9A, and may be affixed to the light control sheet 3 via a second transparent adhesive layer 9A. Alternatively, the transparent adhesive layers 9A may be omitted.

The colored transparent substrate 9 absorbs part of the light incident from the rear side 1B of the display device 1. The colored transparent substrate 9 can maintain transparency of the display device 1 and at the same time can blur the image viewed from the rear side 1B. Also, the colored transparent substrate 9 can prevent entry of light from the rear side 2B of the transparent display 2, by which the image displayed on the transparent display 2 can be made clearer when viewed from the front side 1A of the display device 1.

As described above, according to the sixth embodiment, the following effects can be achieved in addition to the effects (1-1) to (1-7) of the first embodiment and the effect (4-1) of the fourth embodiment.

(6-1) Since the colored transparent substrate 9 is located between the transparent display 2 and the light control sheet 3, when the light control sheet 3 is brought into the transparent state, transparency of the display device 1 can be maintained and at the same time the image 30 can be blurred when viewed from the rear side 1B. Furthermore, since part of the light incident from the rear side 1B can be absorbed by the colored transparent substrate 9, the image 30 can be made clearer when viewed from the front side 1A.

(Seventh embodiment)

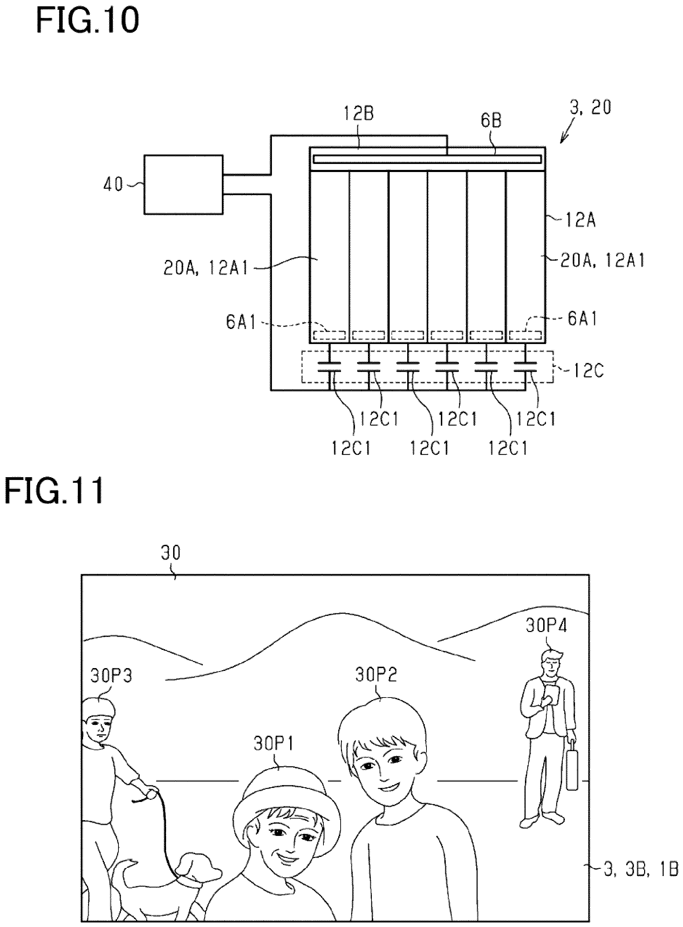

Referring to Figs. 10 to 17, a seventh embodiment of a display device will be described. In the display device according to the present embodiment, configurations of the display devices of the first to sixth embodiments can be combined.

(Configuration)

Fig. 10 shows a structure of the light control sheet 3 seen from a viewpoint facing the first transparent electrode layer 12A of the light control sheet 3. In Fig. 10, the first transparent support layer 13A of the light control sheet 3 is omitted for convenience of explanation.

As shown in Fig. 10, the first transparent electrode layer 12A is divided into multiple electrode sections 12A1. Each electrode section 12A1 is insulated from the adjacent electrode sections 12A1. The boundary between each electrode section 12A1 and an adjacent electrode section 12A1 may be a break, or may be an area where the material constituting the first transparent electrode layer 12A has been denatured and thereby lost conductivity. One first terminal 6A1 is connected to each electrode section 12A1.

In contrast, the second transparent electrode layer 12B is a single layer. In other words, the second transparent electrode layer 12B is not divided. In the thickness direction of the light control sheet 3, the second transparent electrode layer 12B faces all of the electrode sections 12A1. One second terminal 6B is connected to the second transparent electrode layer 12B. The second terminal 6B is preferred to have a length extending over substantially the entire length of the second transparent electrode layer 12B in the direction in which the electrode sections 12A1 are arranged. The second transparent electrode layer 12B may also include the same number of electrode sections as does the first transparent electrode layer 12A, with each electrode section insulated from the adjacent electrode sections. In this case, the electrode sections of the second transparent electrode layer 12B may be opposed to the respective electrode sections 12A1 of the first transparent electrode layer 12A. Also, one second terminal may be connected to each electrode section of the second transparent electrode layer 12B.

The light control area 20 of the light control sheet 3 is divided into multiple light control sections 20A. The number of the light control sections 20A is equal to the number of the electrode sections 12A1 of the first transparent electrode layer 12A. Each light control section 20A includes any one of the multiple electrode sections 12A1. In the light control sheet 3, each electrode section 12A1 is insulated from the adjacent electrode sections 12A1, and one first terminal 6A1 is connected to each electrode section 12A1. Therefore, each of the multiple light control sections 20A can switch between the transparent state and the opaque state, independent of other light control sections 20A.

In the present embodiment, the multiple electrode sections 12A1 are connected to the control device 40 and thereby connected to a single power source. The electrode sections 12A1 may be individually connected to respective power sources. If the multiple electrode sections 12A1 are connected to a single power source, the light control sheet 3 may include a voltage divider 12C as shown in Fig. 10. The voltage divider 12C may include one or more capacitors 12C1, and each of the capacitors 12C1 may be connected to any one of the electrode sections 12A1 in series. In the example shown in Fig. 10, each of the electrode sections 12A1 is connected to corresponding one of the capacitors 12C1 in series; however, only part of the electrode sections 12A1 among the multiple electrode sections 12A1 may be connected to respective capacitors 12C1.

The multiple capacitors 12C1 include capacitors 12C1 with a first capacitance value and capacitors 12C1 with a second capacitance value different from the first capacitance value. In the multiple capacitors 12C1, the capacitance value of each capacitor 12C1 may be different from the capacitance values of all the other capacitors 12C1. If the light control sheet 3 is provided with the voltage divider 12C, the magnitude of the drive voltage applied to each electrode section 12A1 can be changed according to the capacitance value of the capacitor 12C1 connected to the electrode section 12A1. The light control sheet 3 does not have to include the voltage divider 12C.

The control device 40 may be configured to control driving of the light control sections 20A according to driving of the transparent display 2. The control device 40 may be configured to generate a drive signal for the light control sheet 3 according to display data and output the drive signal to the light control sheet 3, every time such display data for displaying the image 30 on the transparent display 2 is switched over.

For example, the control device 40 may associate driving of the light control sheet 3 with each image frame for displaying the image 30 on the transparent display 2. In other words, the control device 40 may associate switching of the image frames with switching of driving of the light control sheet 3. In this case, the control device 40 may store the image frames and the driving sequence of the light control sheet 3 in advance, and may associate the image frames with the driving sequence. Alternatively, the control device 40 may control driving of the individual light control sections 20A based on an image frame when the image frame is displayed. Alternatively, while the image 30 is displayed on the transparent display 2, the control device 40 may control driving of the individual light control sections 20A based on a signal inputted from the input operation device 50.

When displaying the image 30, the control device 40 can control the display device 1 to any of the following three control modes. The first mode is a state in which the image 30 displayed on the transparent display 2 is visible from both of the front side 1A and the rear side 1B of the display device 1. The first mode corresponds to the first display state described above. The second mode is a state in which the image 30 displayed on the transparent display 2 is visible from the front side 1A of the display device 1, while the image 30 is invisible from the rear side 1B of the display device 1. In the second mode, the transparent display 2 displays the image 30 so as to be invisible from the rear side 1B of the display device 1, while the light control sheet 3 is in the transparent state. The third mode, similarly to the second mode, is a state in which the image 30 displayed on the transparent display 2 is visible from the front side 1A of the display device 1, while the image 30 is invisible from the rear side 1B of the display device 1. In the third mode, the image 30 is invisible from the rear side 1B of the display device 1 due to the light control sheet 3 being in the opaque state. Therefore, the transparent display 2 may display the image 30 that would have been visible from the rear side 1B of the display device 1 if the light control sheet 3 is in the transparent state. The third mode corresponds to the second display state described above. In the third mode, only part of the light control sections 20A of the light control sheet 3 among the multiple light control sections 20A may be in the opaque state.

(Operation)

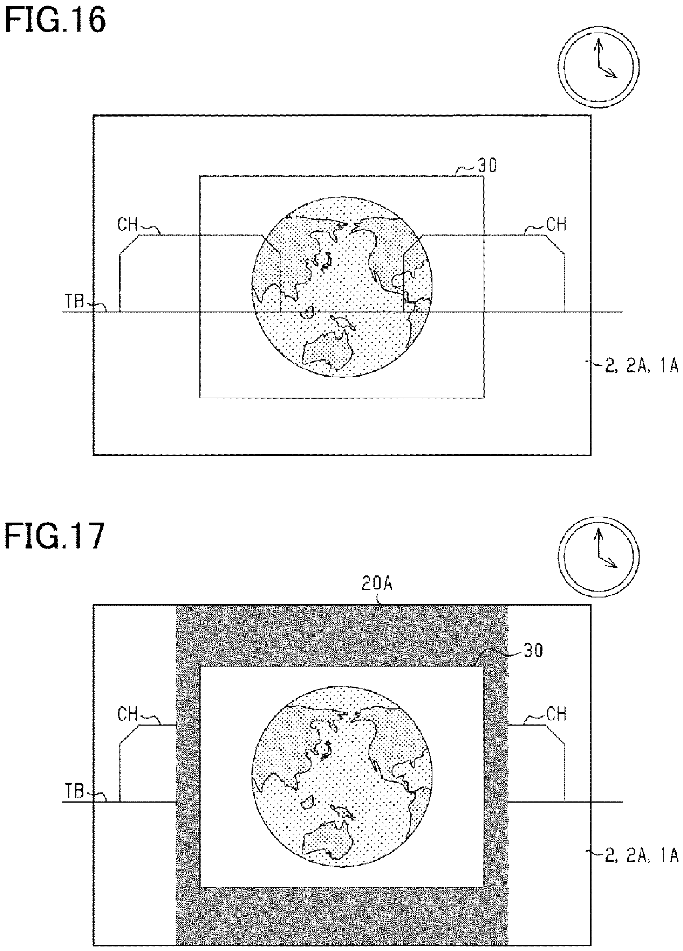

Referring to Figs. 11 to 17, operation of the display device 1 will be described. Figs. 11 to 15 each illustrate operation of the display device 1 in the case where the viewer 101 views the display device 1 from the rear side 1B thereof. Figs. 16 and 17 each illustrate operation of the display device 1 in the case where the viewer 100 views the display device 1 from the front side 1A thereof.

Fig. 11 shows the image 30 as seen through from the rear side 1B of the display device 1, i.e., the second surface 3B of the light control sheet 3, when the light control sheet 3 is entirely in the transparent state.

As shown in Fig. 11, the image 30 includes four people. It may be required that, of these people, a first person 30P1 and a second person 30P2 at the center are allowed to be displayed, but a third person 30P3 and a fourth person 30P4 at the ends of the image 30 are displayed so as to be unidentifiable, from the perspective of privacy protection.

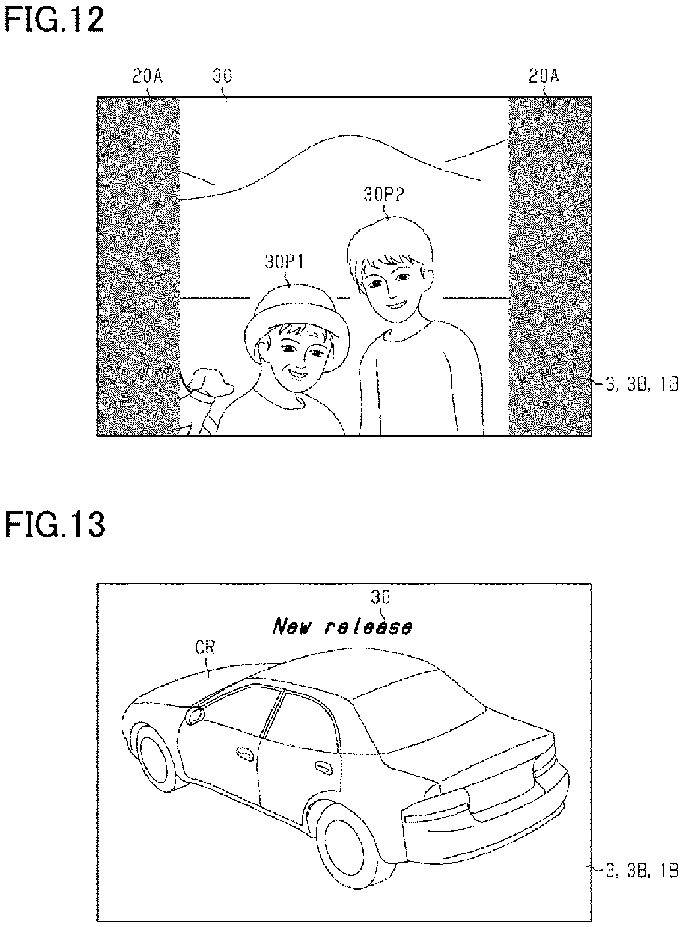

In this case, as shown in Fig. 12, of the multiple light control sections 20A, the light control sections 20A overlapping with the third person 30P3 in the image 30 in the thickness direction of the display device 1, and the light control sections 20A overlapping with the fourth person 30P4 in the image 30 in the thickness direction of the display device 1 are brought into the opaque state. Thus, the third and fourth persons 30P3 and 30P4 in the image 30 can be concealed from the viewer 101 viewing the image 30 from the rear side 1B of the display device 1. However, the viewer 101 can view the first and second persons 30P1 and 30P2 in the image 30 because the light control sections 20A overlapping with these persons in the thickness direction of the display device 1 among the multiple light control sections 20A are transparent.

In this way, according to the display device 1, the image 30 displayed on the transparent display 2 and viewed by the viewer 101 can be changed such that part of the image 30 is invisible from the rear side 1B of the display device 1, without changing the image frame configuring the image 30.

Also, for example, in the case where the size of the image frame is smaller than the size of the transparent display 2, the light control sections 20A overlapping with portions outside the image 30 in the transparent display 2 in the thickness direction of the display device 1 are preferred to be opaque among the multiple light control sections 20A. Thus, compared to the case where portions outside the image 30 in the transparent display 2 are black, the viewer 101 is less likely to focus their attention on the portions outside the image 30.

Figs. 13 to 15 each illustrate operation of the display device 1 in the case where the display device 1 is located between an exhibit and the viewer 101. The display device 1 may configure part of a show window equipped in a commercial facility, for example. Alternatively, the display device 1 may be installed in the commercial facility so as to be visible from the show window.

As shown in Fig. 13, an automobile CR as an example of an exhibit is located on the opposite side to the viewer 101 with respect to the display device 1. The exhibit may be, for example, clothing, home appliances, toys, or food items. The transparent display 2 displays the image 30 at a position not overlapping with the automobile CR in the thickness direction of the display device 1. In this case, since the entire light control sheet 3 is in the transparent state, the automobile CR and the image 30 are both entirely visible to the viewer 101.

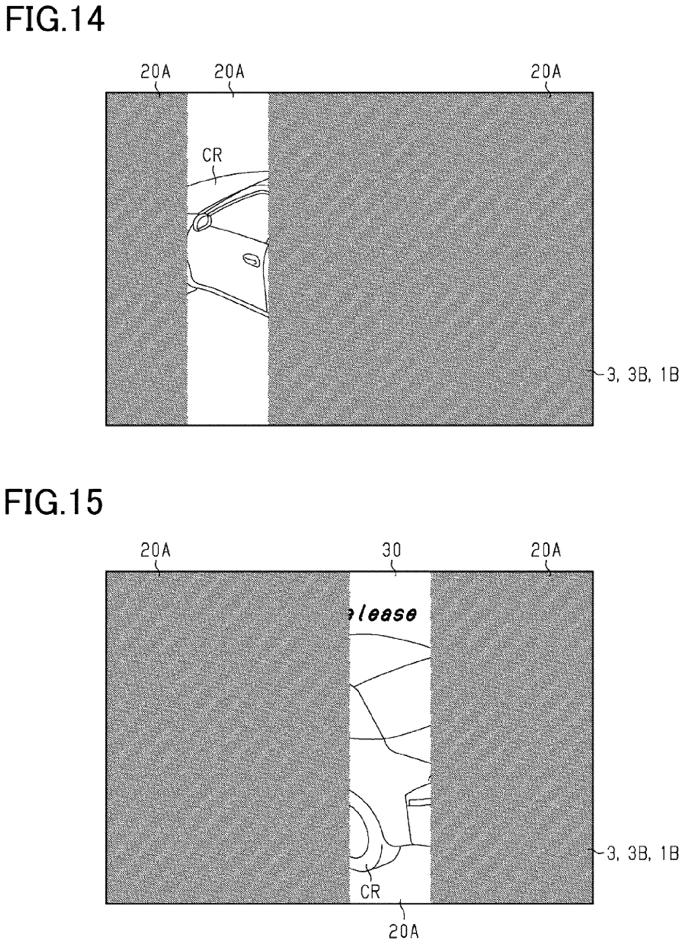

As shown in Fig. 14, for example, the display device 1 can be driven such that only one light control section 20A among the multiple light control sections 20A is in the transparent state and the remaining light control sections 20A are in the opaque state. Thus, the viewer 101 can view only part of the automobile CR and cannot view the entire image 30.

As shown in Fig. 15, for example, a first light control section 20A among the multiple light control sections 20A may be in the transparent state at a first timing, while a second light control section 20A may be in the transparent state at a second timing different from the first timing, and the remaining light control sections 20A may be in the opaque state. At the second timing, the viewer 101 can view a portion of the automobile CR which is different from the portion viewed by the viewer 101 at the first timing. Also, at the second timing, the viewer 101 can view a portion of the image 30.

Thus, the viewer 101 on the outside of the commercial facility may be allowed to view only a portion of the exhibit, and this can urge the viewer 101 to have a desire to see the entire exhibit and thereby can guide the viewer 101 from the outside of the commercial facility into the inside.

The display device 1 may be used as follows. Specifically, for example, the display device 1 may be installed in a window of a restaurant, such as a fast food restaurant, through which the inside of the restaurant is visible from outside the restaurant. In this case, the light control sheet 3 of the display device 1 may be on the outside of the restaurant, and the transparent display 2 may be on the inside of the restaurant. With the light control sheet 3 being in the opaque state, the inside of the restaurant is prevented from being viewed from outside the restaurant. On the other hand, the transparent display 2 can display the image 30 which the restaurant desires to present to the consumers in the restaurant.

Figs. 16 and 17 illustrate an operation of the display device 1 in the case where an object is located on the opposite side to the viewer 100 with respect to the display device 1.

As shown in Fig. 16, the display device 1 is installed in a room, for example. A portion of a desk TB and a portion of a chair CH as an example of objects can be seen on the opposite side to the viewer 100 with respect to the display device 1. When the light control sheet 3 is in the transparent state and the transparent display 2 displays the image 30, the portion of the desk TB and the portion of the chair CH are visible via the display device 1. Therefore, the viewer 100 views an image in which the portion of the desk TB and the portion of the chair CH are overlapped with the image 30. Therefore, it is difficult for the viewer 100 to view the image 30.

As shown in Fig. 17, the light control sections 20A overlapping with the image 30 in the thickness direction of the display device 1 are in the opaque state among the light control sections 20A included in the light control sheet 3. Thus, since the portion of the desk TB and the portion of the chair CH are difficult to be seen through the light control sections 20A in the opaque state, the viewer 100 can view the image 30 not overlapped with the portion of the desk TB and the portion of the chair CH.

As described above, according to the seventh embodiment of the display device, the following effects can be achieved.

(7-1) Depending on the usage conditions of the display device 1, only part of the light control sections 20A among several of them can be brought into the transparent state, or a light control section 20A in the transparent state can be changed from the first light control section 20A to the second light control section 20A.

(Modifications)

The display device 1 may include two or more light control sheets 3. If the light control sheet 3 includes two or more light control sheets 3, these light control sheets 3 may be arranged so that each light control sheet 3 faces an area of the transparent display 2 which is not faced by other light control sheets 3. Thus, as in the case of a single light control sheet 3 including multiple light control sections 20A, the states of the individual light control sheets 3 seen through the transparent display 2 can be independently changed, between a portion of the transparent display 2 overlapping with a first light control sheet 3 and a portion thereof overlapping with a second light control sheet 3 in the thickness direction of the display device 1. If the display device 1 includes two or more light control sheets 3, all the light control sheets 3 may be connected to a single power source, or they may be connected to respective separate power sources.

Diffuse transmittance of the light control sections 20A is not limited to have two levels of high diffuse transmittance and low diffuse transmittance, but may have three or more diffuse transmittances including intermediate diffuse transmittance between high and low diffuse transmittances. Specifically, the display device 1 may be configured such that gradation of the light control sections 20A can be changed in multiple gradations of three or more. In this case, the contrast between the image 30 displayed on the transparent display 2 and the state exhibited by the light control sheet 3 can be adjusted according to the diffuse transmittance in the light control sheet 3, i.e., the diffuse transmittance in the light control sections 20A.

(Eighth embodiment)

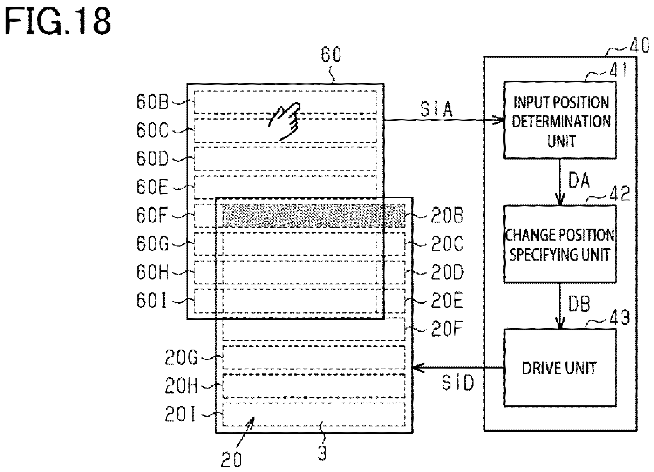

Referring to Fig. 18, an eighth embodiment of a display device will be described.

(Configuration)

As shown in Fig. 18, a display device 1 can include a detection sheet 60 in addition to the transparent display 2 and the light control sheet 3 described above. In the display device 1, the detection sheet 60 is located between the transparent display 2 and the light control sheet 3 in the thickness direction of the display device 1. In the present embodiment, the distance between the transparent display 2 and the light control sheet 3 may be 5 mm or more in terms of air equivalent in a state in which the detection sheet 60 is located therebetween.

The detection sheet 60 and the light control sheet 3 have light transmissivity allowing passage of visible light. The detection sheet 60 and the light control sheet 3 have substantially the same size. The detection sheet 60 is overlapped with the light control sheet 3 so that the outer edges of the detection sheet 60 and that of the light control sheet 3 substantially match each other. The detection sheet 60 and the light control sheet 3 are configured as an integral structure. The detection sheet 60 and the light control sheet 3 being substantially in the same size not only means that they have the same size, but also means that, for example, there may be a size difference between the two sheets due to the edge of at least one sheet being trimmed.

The detection sheet 60 includes multiple detection sections 60B, 60C, 60D, 60E, 60F, 60G, 60H, and 60I. The detection sections 60B to 60I are positioned in different areas of the detection sheet 60. In these different areas, no portion of any one area overlaps with any other areas, and the entirety of any one area does not overlap with any other areas. The detection sections 60B to 60I are each configured to be able to detect changes in capacitance substantially in the whole area occupied by the detection section. The detection sections 60B to 60I each use either a surface-type system including a single conductive layer, or a projection-type system including two conductive layers facing each other. The detection sections 60B to 60I may all use one system type or may use two system types. The detection sections 60B to 60I each have a rectangular shape extending in the horizontal direction. The detection sections 60B to 60I are regularly arranged in the vertical direction perpendicular to the horizontal direction at regular intervals without overlapping with each other. Hereinafter, the regular arrangement of the detection sections 60B to 60I is referred to as a second arrangement.

The light control sheet 3 includes multiple light control sections 20B, 20C, 20D, 20E, 20F, 20G, 20H, and 20I. The multiple light control sections 20B to 20I are established within one light control area 20. The light control sections 20B to 20I are each configured to be able to change transmittance of diffusion light in therein. The light control sections 20B to 20I each use either a normal-type system or a reverse-type system. The light control sections 20B to 20I may all use one system type or may use two or more system types different from each other. The control sections 20B to 20I each have a rectangular shape extending in the horizontal direction. The control sections 20B to 20I are regularly arranged in the vertical direction at regular intervals without overlapping with each other. Hereinafter, the regular arrangement of the control sections 20B to 20I is referred to as a first arrangement. The regularity of the first arrangement is the same as the regularity of the second arrangement.

Each of the control sections 20B to 20I faces one of the detection sections 60B to 60I, which is different from the detection sections 60B to 60I faced by other light control sections 20B to 20I. For example, the light control section 20B may face the detection section 60B, and the light control section 20C may face the detection section 60C. Also, the light control section 20H may face the detection section 60H, and the light control section 20I may face the detection section 60I.

The phrase that "the regularity of the Mth arrangement is the same as the regularity of the Nth arrangement" means at least one of the following: 1) the arrangement direction of elements arranged according to the Mth arrangement (hereinafter, these elements are defined as elements M in the present disclosure) is the same as the arrangement direction of elements arranged according to the Nth arrangement (hereinafter, these elements are defined as elements N in the present disclosure); 2) the relative size relationship of the elements M with respect to the arrangement order of the elements M is the same as the relative size relationship of the elements N with respect to the arrangement order of the elements N; and 3) the relative positional relationship of the elements M with respect to the arrangement order of the elements M is the same as the relative positional relationship of the elements N with respect to the arrangement order of the elements N.

The control device 40 includes an input position determination unit 41, a change position specifying unit 42, and a drive unit 43. The input position determination unit 41, the change position specifying unit 42, and the drive unit 43 are examples of a light control processing unit. The light control processing unit is not limited to those including a central processing unit and a memory and thereby performing various types of processing, described later, all with software. For example, the light control processing unit may include dedicated hardware (application-specific integrated circuit: ASIC) executing at least part of the various types of processing. That is, the light control processing unit can be configured as a circuit including 1) one or more dedicated hardware circuits, such as ASIC, 2) one or more processors (microcomputers) operating according to computer programs (software), or 3) a combination thereof.

The result of detection performed by the detection sheet 60 is supplied to the input position determination unit 41 as a detection signal SiA. Based on the detection signal SiA, the input position determination unit 41 determines whether the detection sections 60B to 60I have detected changes in capacitance. The input position determination unit 41 outputs the result of determination that it has made.

For example, when the user taps the detection section 60B via the transparent display 2, a detection signal SiA indicating that changes in capacitance have been detected by the detection section 60B and no changes in capacitance have been detected by other detection sections 60C to 60I may be supplied to the input position determination unit 41. The input position determination unit 41 outputs the result of determination indicating that the detection section 60B is an input target and other detection sections 60C to 60I are not input targets.

The result of determination made by the input position determination unit 41 is supplied to the change position specifying unit 42 as determination data DA. The change position specifying unit 42 associates each of the detection sections 60B to 60I with a unique one of the light control sections 20B to 20I according to the arrangement of the detection sections 60B to 60I. Specifically, the change position specifying unit 42 associates each of the detection sections 60B to 60I with a unique one of the light control sections 20B to 20I sequentially from the top in the vertical direction according to the eight detection sections 60B to 60I being arranged in the vertical direction. For example, the change position specifying unit 42 may associate the detection section 60B with the light control section 20B, and may associate the detection section 60C with the light control section 20C. Also, the change position specifying unit 42 may associate the detection section 60H with the light control section 20H, and may associate the detection section 60I with the light control section 20I.

Based on the determination data DA, the change position specifying unit 42 handles any of the light control sections 20B to 20I associated with the input target as an output target, and specifies the output target as an output destination of a change signal SiD. Then, the change position specifying unit 42 outputs the result of specification that it has performed. For example, the determination data DA indicating the detection section 60B being an input target and other detection sections 60C to 60I not being input targets may be supplied to the change position specifying unit 42. In this case, based on the determination data DA, the change position specifying unit 42 may handle the light control section 20B associated with the detection section 60B as an output target, and specify the light control section 20B as an output destination of a change signal SiD. Then, the change position specifying unit 42 may output the result of specification indicating the output destination of the change signal SiD being the light control section 20B.

The specification result from the change position specifying unit 42 is supplied to the drive unit 43 as specification data DB. The drive unit 43 generates a change signal SiD based on the specification data DB. The change signal SiD is a drive signal for changing the current light transmittance of the light control sections 20B to 20I. For example, when the drive unit 43 expresses the light transmittance of the light control sections 20B to 20I with two gradations of high gradation and low gradation, the drive unit 43 may generate a change signal SiD for reversing the current light transmittance. The drive unit 43 outputs the change signal SiD to the output target based on the specification data DB. For example, specification data DB indicating the light control section 20B being an output target may be supplied to the drive unit 43. In this case, the drive unit 43 may output a change signal SiD to the light control section 20B based on the specification data DB.

(Operation)

According to the display device 1 of the present embodiment, when the user taps the detection section 60B in a state in which the light control sections 20B to 20I are transparent, the detection section 60B detects changes in capacitance, and other detection sections 60C to 60I do not detect changes in capacitance. Consequently, a change signal SiD is outputted to the light control section 20B to change the state of the light control section 20B from transparent to opaque.

Also, for example, when the user taps the detection section 60D in a state in which the light control sections 20B to 20H are transparent, the detection section 60D detects changes in capacitance, and other detection sections 60B, 60C and 60E to 60I do not detect changes in capacitance. Consequently, a change signal SiD is outputted to the light control section 20D to change the state of the light control section 20D from transparent to opaque.

According to the display device 1, part of the light control area 20 can switch the state between transparent and opaque in response to the detection sheet 60 of the display device 1 being tapped by the user. Accordingly, for example, in order to prevent the image 30 displayed on the transparent display 2 from being viewed from the rear side 1B of the display device 1, the user can tap the detection sheet 60 to switch the state of at least part of the light control area 20 from transparent to opaque. Thus, the image 30 displayed on the transparent display 2 is prevented from being viewed from the rear side 1B of the display device 1.

Also, for example, if the image 30 displayed on the transparent display 2 overlaps with an object seen through the rear side 1B of the display device 1 by which the image 30 becomes difficult to see, the user can tap the detection sheet 60 to switch the state of at least part of the light control area 20 from transparent to opaque. Thus, since the image 30 displayed on the transparent display 2 is prevented from overlapping with an object, the user can easily view the image 30.

In any of the cases mentioned above, the user views the image 30 displayed on the front side 1A of the display device 1.

As described above, according to the eighth embodiment of the display device, the following effects can be achieved.

(8-1) Since the state of at least part of the light control area 20 can be switched from transparent to opaque, or vice versa, in response to the user tapping the detection sheet 60, whether to allow the image 30 displayed on the transparent display 2 to be seen through the rear side 1B can be determined by the user as desired.

(Modifications)

Diffuse transmittance of the light control sections 20B to 20I is not limited to have two levels of high diffuse transmittance and low diffuse transmittance, but may have three or more diffuse transmittances including intermediate diffuse transmittance between high and low diffuse transmittances. Specifically, the display device 1 may be configured such that gradation of the light control sections 20B to 20I can be changed in multiple gradations of three or more. In this case, the storage unit provided in the change position specifying unit 42 can store input patterns in association with change signals SiD for obtaining different levels of light transmittance. The change position specifying unit 42 outputs a change signal SiD associated with the matched input pattern to the output target through driving of the drive unit 43.

[Test examples]

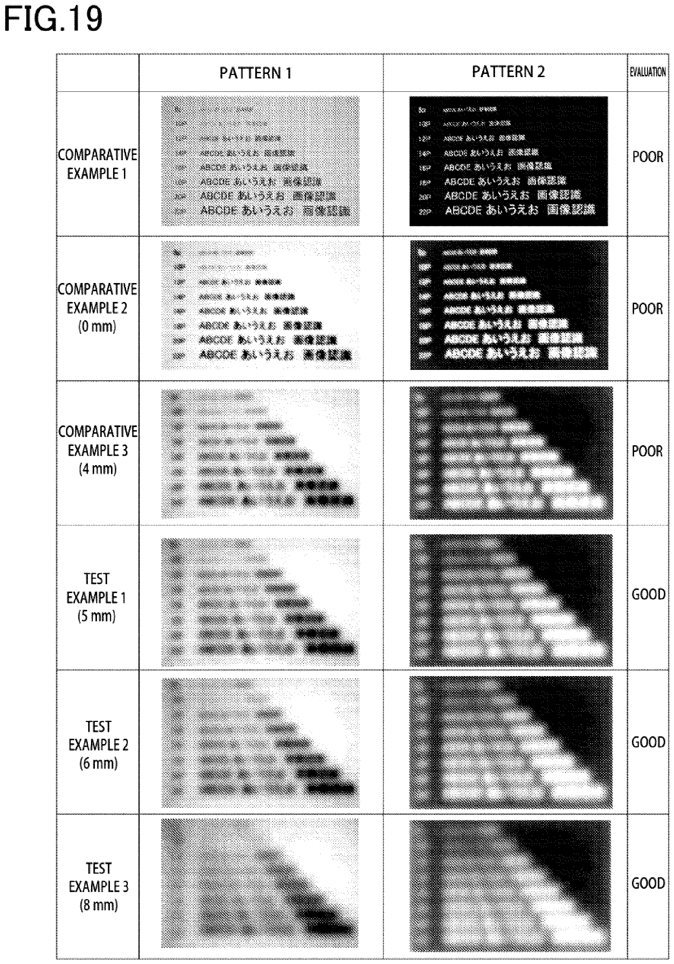

Referring to Figs. 19 to 21, test examples of the display device will be specifically described. It should be noted that these test examples should not limit the present invention.

[Test Example 1]

A normal type light control sheet was prepared as a sample. The light control sheet had a haze of 98% and a clarity of 40% in the opaque state in which no drive voltage was applied. The light control sheet had a configuration similar to the normal type light control sheet 3 of the first embodiment.

In order to confirm clarity of the image when viewed from the rear side of the display device, a tablet computer (product name: ThinkPad tablet (trademark), screen size: 12 inches, aspect ratio: 4:3, 2160×1440 pixels, manufactured by Lenovo Group Limited) was used in place of the transparent display. The above sample in the opaque state was placed so as to face the surface of the display of the tablet computer. The distance, i.e., spacing, between the surface of the display and the first surface of the sample facing the display was set to 5 mm. In other words, the distance between the surface of the display and the first surface of the sample was set to 5 mm in air-equivalent length. In this manner, a display device of Test Example 1 was obtained.

[Test Example 2]

The display device of Test Example 2 was prepared to have a configuration similar to Test Example 1, except that the distance between the surface of the display and the first surface of the sample was set to 6 mm.

[Test Example 3]

The display device of Test Example 3 was prepared to have a configuration similar to Test Example 1, except that the distance between the surface of the display and the first surface of the sample was set to 8 mm.

[Test Example 4]

The display device of Test Example 4 was prepared to have a configuration similar to Test Example 1, except that the distance between the surface of the display and the first surface of the sample was set to 10 mm.

[Test Example 5]

The display device of Test Example 5 was prepared to have a configuration similar to Test Example 1, except that the distance between the surface of the display and the first surface of the sample was set to 15 mm.

[Test Example 6]

The display device of Test Example 6 was prepared to have a configuration similar to Test Example 1, except that the distance between the surface of the display and the first surface of the sample was set to 16 mm.

[Comparative Example 1]

The display device of Comparative Example 1 was prepared to have a configuration with omission of the light control sheet facing the surface of the display in Test Example 1.

[Comparative Example 2]

The display device of Comparative Example 2 was prepared to have a configuration similar to Test Example 1, except that the surface of the display was brought into close contact with the first surface of the sample to set the distance therebetween to 0 mm.

[Comparative Example 3]

The display device of Comparative Example 3 was prepared to have a configuration similar to Test Example 1, except that the distance between the surface of the display and the first surface of the sample was set to 4 mm.

[Evaluation]

Images including the following patterns were displayed on the displays with the light control sheets being in the opaque state. Specifically, fonts at 8 pt to 48 pt, photographs of people, and photographs of flowers were displayed on the displays. On a 12-inch screen, i.e., a screen 18.3 cm in height and 24.4 cm in width, 8 pt characters were 1.66 mm in height and width on the display screen, 22 pt characters were 4.5 mm in height and width on the display screen, and 48 pt characters were 10.0 mm in height and width on the display screen. Display method for the characters and photographs was set to the following Patterns 1 to 3.
Pattern 1: Black characters at 8 pt to 22 pt were displayed on a white background.
Pattern 2: White characters at 8 pt to 22 pt were displayed on a black background.
Pattern 3: Black characters at 26 pt to 48 pt and photographs were displayed on a white background.
Pattern 4: White characters at 26 pt to 48 pt and photographs were displayed on a black background.

[Evaluation result]

Evaluation results are shown in Figs. 19 to 21. For the display devices of the test examples and comparative examples, if the pattern displayed on the display and viewed with the naked eye appeared blurred and could maintain confidentiality of the image and protect privacy, the sample was evaluated to be Good. If the pattern appeared particularly blurred and could maintain confidentiality of the image and protect privacy at a high level, the sample was evaluated to be Excellent. For the display devices of the test examples and comparative examples, if the pattern was clearly visible and determined not to be able to maintain confidentiality of the image or protect privacy, the sample was evaluated to be Poor. For the display devices of the test examples and comparative examples, if the image was difficult to distinguish and the clarity was between Good and Poor, the sample was evaluated to be Fair.
Fig. 19 is a table showing evaluations for the degree of blurring when images of Patterns 1 and 2 were displayed on the displays. When the evaluator viewed the display devices with the naked eye, almost all the characters were distinguished on the display device of Comparative Example 1. In the display device of Comparative Example 2, 10 pt characters were difficult to read or slightly difficult to read, and 12 pt characters with a simple configuration, such as a Japanese Hiragana character "i", were distinguishable but 12 pt Japanese Kanji characters with a complicated configuration were indistinguishable. In the display device of Comparative Example 3, almost all the characters were indistinguishable, but 22 pt characters with a simple configuration, such as the Japanese Hiragana character for "i", were distinguishable. Therefore, Comparative Examples 1 to 3 were evaluated to be Poor for maintaining confidentiality of the image and protecting privacy. On the other hand, in Test Examples 1 to 3, all the characters were indistinguishable. Therefore, Test Examples 1 to 3 were evaluated to be Good. Although not shown in Fig. 19, Test Examples 4 to 6 were also evaluated to be Good due to the characters being blurred.

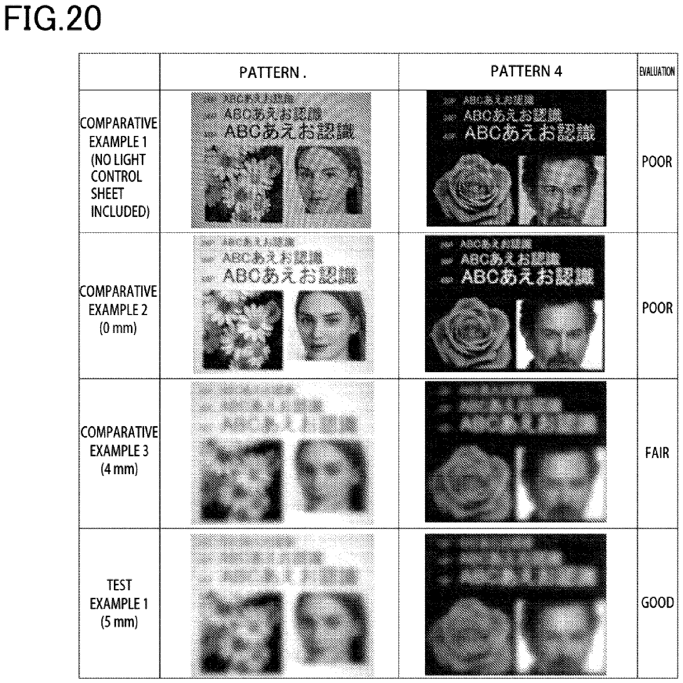

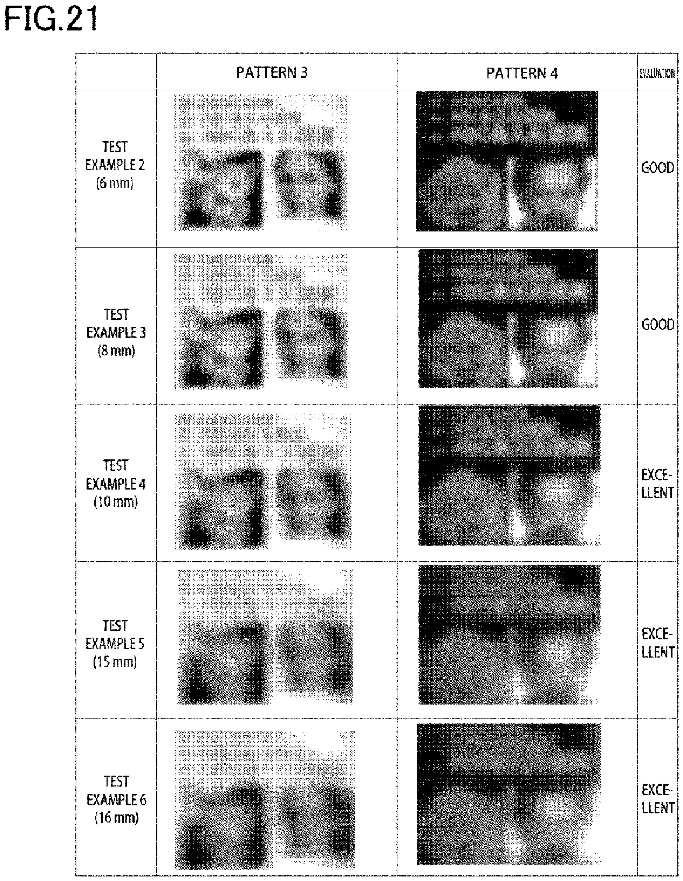

Figs. 20 and 21 are tables showing evaluations for the degree of blurring when images of Patterns 3 and 4 were displayed on the displays. Fig. 20 is a table showing evaluations for the degree of blurring when images of Patterns 3 and 4 were displayed on the displays of the display devices of Comparative Examples 1 to 3 and Test Example 1. In Comparative Examples 1 and 2, almost all the characters and photographs were distinguishable. In Comparative Example 3, 26 pt characters were indistinguishable but 36 pt characters were distinguishable. In addition, in Comparative Examples 1 to 3, contours of photograph details, such as contours of petals, were indistinguishable. Therefore, Comparative Examples 1 and 2 were evaluated to be Poor, and Comparative Example 3, in which characters and photographs were more difficult to distinguish than in Comparative Examples 1 and 2, was evaluated to be Fair.

In Test Example 1, characters and photographs appeared more blurred than in Comparative Example 3. Specifically, in Test Example 1, characters of 26 pt or smaller were indistinguishable. In Test Example 1, the appearance of 36 pt characters differed depending on the types of characters. Specifically, Japanese Hiragana characters for "a", "e" and "o" appeared to be blurred but were distinguishable with extreme difficulty, characters such as A, B and C were difficult to distinguish, and Japanese Kanji characters with many strokes were indistinguishable. In Test Example 1, contours of photograph details were indistinguishable. Therefore, Test Example 1 was evaluated to be Good.

Fig. 12 is a table showing evaluations for the degree of blurring when images of Patterns 3 and 4 were displayed on the displays of the display devices of Test Examples 2 to 6. An image substantially similar to Test Example 1 was visible in Test Example 2, but since characters and photographs appeared more blurred than in Test Example 1, characters were difficult to distinguish. Therefore Test Example 2 was evaluated to be Good. In Test Example 3, 36 pt characters or smaller were indistinguishable, and almost all 48 pt characters were indistinguishable. In Test Example 3, contours of photograph details were indistinguishable. Therefore, Test Example 3 was evaluated to be Good. In Test Examples 4 to 6, none of the characters were distinguishable, and contours of the objects in the photographs were entirely blurred. Therefore, Test Examples 4 to 6 were evaluated to be Excellent.

In this way, according to the evaluation results of the test examples and comparative examples, it was confirmed that, if the distance in terms of air equivalent between the surface of the display and the first surface of the light control sheet was 5 mm or more, the image was blurred when displayed via the light control sheet in the opaque state.

[Reference Signs List]

| 1 | Display device |
| 1A, 2A | Front side |
| 1B, 2B | Rear side |
| 2 | Transparent display |
| 3 | Light control sheet |
| 3A | First surface |
| 3A | Second surface |
| 5 | Transparent support substrate |
| 6 | Space |
| 7 | Transparent substrate |
| 8 | Semi-transparent mirror |
| 11 | Light control layer |
| 11D | Void |
| 11P | Transparent polymer layer |
| 12A | First transparent electrode layer |
| 12B | Second transparent electrode layer |
| 13A | First transparent support layer |
| 13B | Second transparent support layer |
| LCM | Liquid crystal compound |
| DP | Dichroic dye |

**Claims**

1. A display device comprising

a transparent display that includes a front side displaying an image presented to a viewer, and a rear side facing away from the front side and through which the image is visible; and
a light control sheet that includes a light control layer containing a transparent polymer layer with a liquid crystal compound dispersed therein, the light control sheet being able to switch between a transparent state and an opaque state, wherein
a distance between the rear side of the transparent display and a first surface of the light control sheet facing the rear side is 5 mm or more in air-equivalent length.

2. The display device according to claim 1, wherein
the distance between the rear side of the transparent display and the first surface of the light control sheet is 50 mm or less in air-equivalent length.

3. The display device according to claim 1, wherein
an air layer is located between the rear side of the transparent display and the first surface of the light control sheet.

4. The display device according to claim 1, wherein
a transparent substrate is located between the rear side of the transparent display and the first surface of the light control sheet.

5. The display device according to claim 1, comprising
a semi-transparent mirror having a reflection surface and located between the rear side of the transparent display and the first surface of the light control sheet.

6. The display device according to claim 4, wherein
the transparent substrate located between the rear side of the transparent display and the first surface of the light control sheet is colored.

7. The display device according to any one of claims 1 to 6, wherein

the light control sheet includes

the light control layer,
two transparent electrode layers sandwiching the light control layer, and
two transparent support layers sandwiching the light control layer and the two transparent electrode layers;

the light control layer contains the transparent polymer layer defining multiple voids therein, and the liquid crystal compound and a dichroic dye located in the voids; and
alignment of the liquid crystal compound and the dichroic dye is controlled according to a potential difference between the two transparent electrode layers.

8. The display device according to any one of claims 1 to 7, further comprising
a transparent support substrate that supports a second surface of the light control sheet facing away from the first surface.

9. The display device according to any one of claims 1 to 8, wherein
the light control sheet in the opaque state has a haze of 85% or more.

10. The display device according to any one of claims 1 to 9, wherein
the light control sheet in the opaque state has a clarity of 60% or less.

11. The display device according to any one of claims 1 to 10, wherein
the light control sheet in the opaque state has a total light transmittance of 20% or less.

12. The display device according to any one of claims 1 to 11, wherein
the light control sheet in the transparent state has a total light transmittance of 40% or more.

# FIG.1

# FIG.2

# FIG.3

# FIG.4

# FIG.5

# FIG.6

# FIG.7

# FIG.8

# FIG.9

# FIG.10

# FIG.11

## FIG.12

## FIG.13

## FIG.14

20A    20A                              20A

CR

3, 3B, 1B

## FIG.15

20A                    30              20A

lease

3, 3B, 1B

CR

20A

FIG.16

FIG.17

# FIG.18

# FIG.19

| | PATTERN 1 | PATTERN 2 | EVALUATION |
|---|---|---|---|
| COMPARATIVE EXAMPLE 1 | | | POOR |
| COMPARATIVE EXAMPLE 2 (0 mm) | | | POOR |
| COMPARATIVE EXAMPLE 3 (4 mm) | | | POOR |
| TEST EXAMPLE 1 (5 mm) | | | GOOD |
| TEST EXAMPLE 2 (6 mm) | | | GOOD |
| TEST EXAMPLE 3 (8 mm) | | | GOOD |

# FIG.20

| | PATTERN . | PATTERN 4 | EVALUATION |
|---|---|---|---|
| COMPARATIVE EXAMPLE 1 (NO LIGHT CONTROL SHEET INCLUDED) | | | POOR |
| COMPARATIVE EXAMPLE 2 (0 mm) | | | POOR |
| COMPARATIVE EXAMPLE 3 (4 mm) | | | FAIR |
| TEST EXAMPLE 1 (5 mm) | | | GOOD |

# FIG.21

| | PATTERN 3 | PATTERN 4 | EVALUATION |
|---|---|---|---|
| TEST EXAMPLE 2 (6 mm) | | | GOOD |
| TEST EXAMPLE 3 (8 mm) | | | GOOD |
| TEST EXAMPLE 4 (10 mm) | | | EXCE-LLENT |
| TEST EXAMPLE 5 (15 mm) | | | EXCE-LLENT |
| TEST EXAMPLE 6 (16 mm) | | | EXCE-LLENT |

## INTERNATIONAL SEARCH REPORT

| International application No. |
| --- |
| **PCT/JP2022/047652** |

**A. CLASSIFICATION OF SUBJECT MATTER**

*G09F 9/00*(2006.01)i; *G09F 9/40*(2006.01)i; *G02F 1/13*(2006.01)i; *G02F 1/1334*(2006.01)i
FI: G09F9/00 324; G09F9/00 313; G09F9/40 303; G02F1/13 505; G02F1/1334

According to International Patent Classification (IPC) or to both national classification and IPC

**B. FIELDS SEARCHED**

Minimum documentation searched (classification system followed by classification symbols)

G09F9/00; G09F9/40; G02F1/13; G02F1/1334

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | WO 2020/121779 A1 (AGC INC.) 18 June 2020 (2020-06-18) <br> paragraphs [0010]-[0042], fig. 1, 2 | 1-4, 6-12 |
| Y | | 5 |
| Y | US 2014/0300830 A1 (WANG, Jiansheng) 09 October 2014 (2014-10-09) <br> paragraphs [0057], [0067]-[0075], fig. 1-10 | 5 |
| A | WO 2018/207522 A1 (PANASONIC IP MAN CO LTD) 15 November 2018 (2018-11-15) <br> entire text, all drawings | 1-12 |
| A | JP 2016-020959 A (CANON KK) 04 February 2016 (2016-02-04) <br> entire text, all drawings | 1-12 |
| A | KR 10-2015-0047191 A (LG DISPLAY CO., LTD.) 04 May 2015 (2015-05-04) <br> entire text, all drawings | 1-12 |
| A | US 2014/0192281 A1 (DISNEY ENTERPRISES, INC.) 10 July 2014 (2014-07-10) <br> entire text, all drawings | 1-12 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **21 February 2023** | **07 March 2023** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

## INTERNATIONAL SEARCH REPORT
### Information on patent family members

International application No.

**PCT/JP2022/047652**

| Patent document<br>cited in search report | | | Publication date<br>(day/month/year) | Patent family member(s) | | | Publication date<br>(day/month/year) |
|---|---|---|---|---|---|---|---|
| WO | 2020/121779 | A1 | 18 June 2020 | EP | 3896678 | A1 | |
| | | | | paragraphs [0010]-[0041], fig.<br>1, 2 | | | |
| | | | | CN | 113366554 | A | |
| | | | | TW | 202026705 | A | |
| US | 2014/0300830 | A1 | 09 October 2014 | WO | 2014/165336 | A2 | |
| | | | | CN | 105074551 | A | |
| | | | | CA | 2908271 | A | |
| WO | 2018/207522 | A1 | 15 November 2018 | JP | 2020-112581 | A | |
| JP | 2016-020959 | A | 04 February 2016 | (Family: none) | | | |
| KR | 10-2015-0047191 | A | 04 May 2015 | (Family: none) | | | |
| US | 2014/0192281 | A1 | 10 July 2014 | (Family: none) | | | |

Form PCT/ISA/210 (patent family annex) (January 2015)

**EP 4 456 048 A1**

**REFERENCES CITED IN THE DESCRIPTION**

**Patent documents cited in the description**

- JP 2019144508 A